# EUROPÄISCHE PATENTSCHRIFT

(11) **EP 3 384 297 B1**
(45) Veröffentlichungstag und Bekanntmachung des Hinweises auf die Patenterteilung: **27.07.2022**
(21) Anmeldenummer: 16826152.7
(22) Anmeldetag: 30.11.2016
(51) Int. Cl.: G01R 21/06

(54) **TRAGBARES LEISTUNGS- UND MULTIFUNKTIONSGERÄT**
PORTABLE POWER AND MULTIFUNCTIONAL DEVICE
APPAREIL DE PUISSANCE MULTIFONCTIONS PORTABLE

(30) Priorität: 30.11.2015 DE 202015008189 U
(43) Veröffentlichungstag der Anmeldung: 10.10.2018
(73) Patentinhaber: Ehling, Martin, 95488 Eckersdorf (DE)
(72) Erfinder: Ehling, Martin, 95488 Eckersdorf (DE)
(74) Vertreter: Küchler, Stefan
(86) Internationale Anmeldenummer: PCT/IB2016/001695
(87) Internationale Veröffentlichungsnummer: WO 2017/093792

(56) Entgegenhaltungen:
- EP-A1- 1 012 608
- AU-B2- 2012 241 185
- JP-A- 2011 027 589
- US-A- 4 829 239
- US-A- 5 544 089
- US-A- 6 043 640
- US-A1- 2011 012 589
- US-A1- 2015 293 570

## Beschreibung

Die Erfindung richtet sich auf ein tragbares, in ein Energiemanagementsystem (EMS) integrierbares Leistungs- und Multifunktionsmessgerät mit wenigstens einem Anschluss für einen Spannungsabgriff und wenigstens einem Anschluss für einen Stromsensor (für ein Drehstromnetz bspw. drei Stromsensoren), sowie mit einem Berechnungsmodul, um aus gemessenen Strom- und Spannungswerten die Leistung und ggf. andere Parameter, bspw. für eine Netzanalyse, zu berechnen.

Die US 4 829 239 A offenbart ein tragbares Leistungsmessgerät wobei zwei Hallsensoren einen einzelnen Phasenstrom messen.

Für die feste Installation sind Leistungszähler weit verbreitet, welche jedoch nicht einen aktuellen Leistungswert liefern, sondern eine beispielsweise aus einem Netz entnommene oder in dieses eingespeiste Leistung kontinuierlich aufaddieren.

Im Allgemeinen kann ein aktueller Leistungswert nur indirekt ermittelt werden, nämlich durch eine Strom- und eine Spannungsmessung, und aus den so gewonnenen Strom- und Spannungswerten kann sodann insbesondere durch eine Multiplikation dieser Werte die Leistung berechnet werden.

Hierfür gibt es fest installierbare Leistungsmessgeräte, beispielsweise zum Einbau in einen Schaltschrank oder in eine Schalttafel. Für viele Anwendungen lohnt sich jedoch ein solches, stationäres Leistungsmessgerät nicht, beispielsweise für die Installation, Wartung oder Prüfung von Anlagen, mit denen ein Monteuer nur kurzzeitig zu tun hat. Dies trifft beispielsweise zu auf Leistungsmessungen an manchen, insbesondere kleineren Solaranlagen. Bei solchen Messungen oder beim Endverbraucher oder bei kleinen und mittleren Betrieben (KMU) sind Messungen oft nur zu Prüfungs- oder Wartungszwecken erforderlich; ansonsten genügt ein Leistungszähler, um den Wert des Energieflusses zu ermitteln.

Daher besteht ein Bedarf nach tragbaren Leistungs- und Multifunktionsmessgeräten, welche zu Prüfzwecken und zur Analyse eingesetzt und anschließend wieder entfernt und verstaut werden können, um an einem anderen Ort wieder verwendet werden zu können.

Sobald jedoch eine Messschaltung nur vorübergehend aufgebaut wird, z.B. auf einer Baustelle, besteht oftmals die Gefahr, dass die verlegten Kabel durch unachtsame Dritte versehentlich verschoben werden, wodurch Messstromkreise aufgetrennt werden können. Dies kann jedoch fatale Folgen haben, da übliche Strommesseinrichtungen nicht im Leerlauf betrieben werden dürfen, weil dann Überspannungen induziert werden, welche die betreffende Messeinrichtung oder das angeschlossene Messgerät zerstören können. Denn oftmals gibt es im Moment des Auftrennens mehrere kurzzeitige, kontaktgebende Rückfederungen, sodass eine Überspannung auch an die Eingangsbeschaltung des Leistungsmessgeräts gelangen kann.

In der VDI-Richtlinie 4602 wird eine Definition für den Begriff "Energiemanagement" gegeben: "Energiemanagement ist die vorausschauende, organisierte und systematisierte Koordination von Beschaffung, Wandlung, Verteilung und Nutzung von Energie zur Deckung der Anforderungen unter Berücksichtigung ökologischer und ökonomischer Zielsetzungen". Im Sinne der vorliegenden Erfindung soll der Begriff "Energiemanagementsystem" darüber hinaus bereits für kleinere digitale Systeme zur reinen Erfassung von Daten betreffend die Erzeugung und/oder den Verbrauch von Energie verwendet werden, über das Monitoring und die Auswertung solcher Energiedaten sowie ggf. weiterer Daten bis hin zu komplexen Management-Prozessen, wo unter bestimmten Gesichtspunkten als Reaktion auf erfasste Verbrauchsdaten steuernd und/oder regelnd in eine Anlage eingegriffen wird.

Die Kompatibilitätsanforderung zu solchen Systemen hat eine Hardware- und eine Software-Komponente. Entscheidend ist dabei, dass der Austausch von digitalen Daten zwischen dem erfindungsgemäßen Leistungs- und Multifunktionsmessgerät einerseits und einem solchen Energiemanagemsystem möglich ist. Dies bedingt das Vorhandensein von digitalen Schnittstellenbausteinen zur seriellen und/oder parallelen Datenübertragung, jedenfalls in Richtung von dem erfindungsgemäßen Leistungs- und Multifunktionsmessgerät zu dem Energiemanagemsystem, vorzugsweise jedoch auch in umgekehrter Datenflußrichtung. Eine solche Schnittstelle muss einem gängigen Industriestandard entsprechen. Ferner muss die Datenübertragung mit einem Übertragungsprotokoll erfolgen, welches ebenfalls dem gängigen Industriestandard entsprechen sollte. Schließlich sollten auch die übertragenen Daten bzw. Datenworte einem üblichen Standard entsprechen. Wenn alle diese Voraussetzungen erfüllt sind, ist ein "intelligenter" Austausch von Daten und deren sinnvolle Einbindung in ein Energiemanagement möglich. Im Rahmen der vorliegenden Erfindung soll eben diese Kompatibilität gegeben sein, weil erst dann die Fähigkeiten des Gerätes sinnvoll zur Geltung kommen.

Aus den Nachteilen des beschriebenen Standes der Technik resultiert das die Erfindung initiierende Problem, ein gattungsgemäßes, tragbares Leistungsmessgerät derart weiterzubilden, dass weder die damit verbundenen Messeinrichtungen bzw. Sensoren noch das Leistungsmessgerät selbst durch versehentlich aufgetrennte Messstromkreise beschädigt werden können.

Die Lösung dieses Problems gelingt dadurch, dass wenigstens ein Anschluss für einen Stromsensor zum Anschliessen einer Rogowskispule oder eines Halleffektsensors oder eines Shunts geeignet ist. Dieser Anschluss kann sich entweder direkt an dem tragbaren Leistungs- und Multifunktionsmessgerät befinden.

Es hat sich erwiesen, dass handelsübliche Stromwandler beim Auftrennen der Primär- und/oder Sekundärleitung zu heftigen Überspannungen neigen, welche für die integrierte Elektronik, aber auch für den Datenaustausch mit extern angeschlossenen Geräten wie Programmiergeräten und/oder Systemkomponenten eines Energiemanagement-Systems, schädlich oder gar fatal sein können, d.h., Fehlfunktionen wie Systemabstürze verursachen können oder gar Beschädigungen oder Zerstörungen nach sich ziehen können. Dies gilt um so mehr bei tragebaren Leistungs- und Multifunktionsmessgeräten, weil dort die Verbindungen zu externen Geräten nicht dauerhaft installiert werden, sondern zumeist nur vorübergehend aufgebaut werden und daher in erhöhtem Maße störanfällig sind.

Indem daher bei solchen Leistungs- und Multifunktionsmessgeräten anstelle von Stromwandlern Rogowskispulen oder Halleffektsensoren oder Shunts verwendet werden, sind nachtelige Effekte auf die Elektronik und die Kommunikation mit extern angeschlossenen Geräten weitgehend eliminiert.

Dabei sieht die Erfindung ein tragbares Leistungs- und Multifunktionsmessgerät gemäss dem Anspruch 1 vor. Übliche Strommesswandler müssen einerseits vollständig um einen Stromleiter herum gelegt werden, damit eine Messung durchgeführt werden kann, wobei ich ihnen nicht unerhebliche Ströme zirkulieren können.

Zum Anlegen und Entfernen muss bei solchen Strommesswandler entweder der Primärstromkreis oder der Sekundärstromkreis aufgetrennt werden, weil beide sich ansonsten nicht durchdringen können. Beim Einsatz tragbarer Messgeräte soll jedoch einerseits oftmals der Hauptstromkreis nicht unterbrochen werden. Andererseits ist das Auftrennen des Sekundärstromkreises meistens ebenfalls schwierig, weil dabei Spannungsspitzen induziert werden können, welche die angeschlossenen Elektronikkomponenten beschädigen oder gar zerstören können.

Indem die Erfindung statt dessen die Verwendung einer Rogowskispule ermöglicht, werden beide nachteiligen Effekte umgangen. Denn eine Rogowskispule kann mechanisch aufgetrennt werden, ohne dass dabei der Sekundärstromkreis unterbrochen wird. Dies rührt daher, weil bei einer Rogowskispule der Leiter des Sekundärstromkreises nur an das Magnetfeld des von dem Primärstrom durchflossenen Leiters gekoppelt wird und zu diesem Zweck den Primärstromleiter nur einmal oder nicht einmal ganz umgibt. Die Sekundärwicklung einer Rogowskispule wird vielmehr an einem mechanischen Ende der rogoskispule beginnend in Sprialform einmal in Umfangsrichtung bis zum anderen, mechanischen Ende gewickelt und dann - vorzugsweise mit einem dem Umfang unmittelbar folgenden Verlauf, also ohne spiraligen Verlauf - wieder zum ursprünglichen Ende zurück. Dies eröffnet die Möglichkeit einer mechanischen Auftrennung der Rogowskispule zwischen deren beiden Enden, wobei die beiden elektrischen Anschlüsse sich am selben Ende der Rogowskispule befinden.

Da eine Rogowskispule darüber hinaus keinen magnetischen kern aufweist, sondern als Luftspule ausgeführt ist, weist sie überdies im Normalfall eine hohe Flexibilität auf und kann also nach Öffnen der nur mechanisch zusammengesteckten Enden leicht aufgebogen werden, bspw. um einen Primärstromleiter herum verlegt zu werden oder von einem Primästromleiter wieder entfernt zu werden.

Die mechanische Steckverbindung zwischen den beiden mechanischen Enden einer Rogowskispule hat keine elektrische Funktion und dient nur dem Zweck, die Ringform der Rogowskispule um den Primärleiter herum mechanisch zu stabilisieren.

Allerdings erfordert der Anschluss einer Rogowskispule eine andere Beschaltung als der Anschluss eines herkömmlichen Strommessers. Denn der bei einer Rogowskispule sekundärseitig fließende Strom ist vergleichsweise klein. Üblicherweise wird das primärseitige Stromsignal von einer Rogowskispule auf den Spannungsbereich von 0 bis 100 mV abgebildet. Deshalb ist ein spezieller Verstärker erforderlich, um das Ausgangssignal der Rogowskispule spannungs- und/oder strommäßig zu verstärken. Im Rahmen eines Leistungsmessgerätes ist ein solcher Verstärker bereits vorgesehen, so dass der Anschluss der Rogowskispule unmittelbar erfolgen kann. Allerdings muss ein solcher Verstärker nicht direkt in das Gerät integriert sein, sondern kann auch als vorzuschaltender Adapter ausgebildet sein.

Im Rahmen einer ersten Ausführungform kann die Verstärkerschaltung für die Rogowskispule als Stomverstärker ausgebildet sein, insbesondere als Verstärker mit einem niederohmigen Ausgang, so dass das Eingangssignal in ein Stromsignal umgewandelt wird, insbesondere in ein Normsignal mit einem Strombereich von 0 bis 5 A, oder in einen Strombereich von 0 bis 20 mA oder von 4 bis 20 mA. Eine solche Schaltung eignet sich besonders für eine Anordnung innerhalb eines Adapters, der zwischen den eigentlichen Stromeingang des Leistungsmessgerätes und die Rogowskispule geschaltet wird, so dass der normale Stromeingang des Leistungsmessgerätes die Rogowskispule nicht anders wahrnimmt als einen üblichen Stromsensor. Eventuell muss für den Betrieb des Adapters bzw. der darin integrierten Elektronik, insbesondere Verstärkerschaltung, eine Stromversorgung vorgesehen sein, über welche der Adapter seine erforderliche Hilfsenergie beziehen kann. Bei einem mehrpoligen Steckanschluss kann eine solche Stromversorgung eventuell gleich integriert sein, so dass der Adapter nur über eine einzige Steckverbindung mit dem erfindungsgemäßen Leistungsmessgerät verbunden wird.

Eine andere Ausführungsform zeichnet sich dadurch aus, dass die Verstärkerschaltung für die Rogowskispule als Spannungsverstärker ausgebildet ist, insbesondere als Verstärker mit einem hochohmigen Ausgang, so dass das Eingangssignal in ein Spannungssignal umgewandelt wird, bspw. in einen Spannungsbereich bis 5 V oder bis 10 V abgebildet wird, insbesondere in einen Spannungsbereich von 0 bis 5 V oder von 0 bis 10 V. Eine solche Schaltung eignet sich besonders zur unmittelbaren Integration in das erfindungsgemäße Leistungsmessgerät. Dort kann dann speziell für den Anschluss einer Rogowskispule eine eigene Steckvorrichtung vorgesehen sein, bspw. eine spezielle Steckbuchse, an welche ausschließlich Rogowskispulen angeschlossen werden. Solchenfalls it zwar neben dem Steckanschluss für einen normalen Stromsensor eine zusätzliche Steckverbindung am Gehäuse des Leistungsmessgerätes vorgesehen; jedoch wird die Bedienung dadurch vereinfacht, indem ein Adapter überflüssig ist. Um Fehlschaltungen auszuschließen, können/sollten die Steckanschlüsse für normale Stromsensoren anders ausgebildet sein als die Steckanschlüsse für Rogowskispulen.

Im Rahmen der vorliegenden Lehre können die Messkabel zwischen dem erfindungsgemäßen Leistungs- und Multifunktionsmessgerät oder einem jenem vorgeschalteten (Verstärkungs-) Adapter und einer Rogowskispule grundsätzlich mit beliebigen Steckverbindern versehen sein, für welche dann an dem Leistungs- und Multifunktionsmessgerät oder dem vorgeschalteten Adapter und/oder an der Rogowskispule geeignete Steckbuchsen bzw. Pendants vorzusehen sind. Infrage kommen hierfür insbesondere Bananenstecker oder Koaxialstecker oder sonstige, in der Industrie übliche oder angebotene Stecker bzw. Steckverbindungen.

Allerdings wird ferner vorgeschlagen, dass wenigstens ein Anschluss an dem erfindungsgemäßen Leistungs- und Multifunktionsmessgerät oder an einem jenem vorgeschalteten (Verstärkungs-) Adapter für einen Sensor, insbesondere für einen Stromsensor oder für eine Rogowskispule, als Steckanschluss mit einer formschlüssigen Verriegelung für ein einzusteckendes Pendant ausgebildet ist, so dass sich die damit verriegelte Steckverbindung von selbst nicht lösen kann. Im Falle einer Unachtsamkeit können sich dann zwar nach wie vor Messkabel verschieben; jedoch nicht so weit, dass davon eine Steckverbindung aufgetrennt wird. Ein geschlossener Stromkreis eines Stromsensors kann also nicht unvermittelt aufgetrennt werden, sodass die Gefahr einer Beschädigung oder Zerstörung des Stromsensors und auch des daran angeschlossenen Leistungs- und Multifunktionsmessgeräts vermieden wird.

Das Leistungsmessgerät zeichnet sich ferner aus durch ein im verriegelten Zustand von der Längsachse oder Steckrichtung der Steckverbindung etwa radial auskragendes Verriegelungselement. Diesem Verriegelungselement obliegt es, mit dem jeweils anderen Steckelement der Steckverbindung einen Formschluss derart auszubilden, dass dadurch eine Bewegung mit einem sich vergrößernden Abstand zwischen den beiden Steckelementen entlang der Streckrichtung ausgeschlossen wird.

Es hat sich als günstig erwiesen, dass ein radial auskragender Abschnitt des Verriegelungselements nach Art einer Rastnase oder eine Sägezahns ausgebildet ist mit einer in Steckrichtung vorne liegenden Anlauframpe und einer in Steckrichtung rückwärtigen, von der Steckrichtung etwa lotrecht durchsetzten Einrastfläche. Mit einer solchen Geometrie wird ein richtungsabhängiges Verhalten der Steckverbindung ermöglicht: In Steckrichtung, also beim Zusammenstecken, erlaubt die Anlauframpe ein allmähliches Ausweichen des Verriegelungselements mit der Folge, dass eine solche Bewegung nicht gehemmt wird. Befindet sich jedoch die rückwärtige Einrastfläche erst einmal jenseits eines darin eingreifenden Vorsprungs an dem anderen Steckelement, so kann sich das Verriegelungselement wieder nach außen bewegen, und die Einrastfläche rastet hinter den betreffenden Vorsprung. In diesem Zustand ist eine Zugbewegung zwischen beiden Steckelementen - also eine Bewegung mit einem sich vergrößernden Abstand zwischen den Steckelementen - nicht möglich, weil die Einrastfläche nicht an dem hintergriffenen Vorsprung vorbeigleiten kann.

Bevorzugt wird das Verriegelungselement im verriegelten Zustand nach außen gedrückt, vorzugsweise durch ein Federelement oder durch einen Spreizungskörper. Ein federndes Element hat den Vorteil, dass es ein Ausweichen des Verriegelungselements zulässt, wenn sich die Anlauframpe an einem Vorsprung des anderen Steckelements entlang schiebt und dabei eine radial nach innen gerichtete Kraft erfährt. Ein Spreizungskörper lässt dagegen eine solche Bewegung jedenfalls nicht generell zu, sondern hintergreift das Verriegelungselement an dessen radial innen liegender Seite und drückt es nach außen bzw. lässt eine Verschiebung nach innen nicht zu. Beide Wirkungen können auch miteinander kombiniert sein, indem je nach Stecktiefe das eine oder andere Element zum Tragen kommt: Sofern die Verbindung noch nicht vollständig zusammengesteckt ist, sollte das Federelement eine weitere Steckbewegung zulassen, während in vollkommen zusammengestecktem Zustand dann auch ein Spreizkörper zum Einsatz kommen kann, um den eingerasteten Zustand zu verriegeln und somit ein ungewolltes Lösen mit vollkommener Sicherheit zu vermeiden.

Das Leistungsmessgerät sieht ferner vor, dass das Verriegelungselement im gelösten Zustand radial nach innen zurückgezogen ist. Hierbei handelt es sich um eine aktive Bewegung, die mittels einer geeigneten Betätigung hervorgerufen wird. Bei radial nach innen zurückgezogenem Verriegelungselement kann dieses dann wieder mühelos an dem Einrastvorsprung des jeweils anderen Steckelements, hinter welchem es in verriegeltem Zustand gefangen war, vorbeigleiten - die Steckverbindung lässt sich lösen.

Als Betätigungselement zur Beeinflussung der Stellung des Verriegelungselements empfiehlt die Erfindung einen längs eines Gewindes am Außenumfang des Steckelements schraubverstellbaren Ring. Dieser sollte derart ausgebildet sein, dass er je nach seiner Drehstellung eine unterschiedliche Radialstellung des Verriegelungselements zur Folge hat. Die betreffenden Bewegungen werden dabei unmittelbar voneinander abgeleitet, d.h., der schraubverstellbare Ring nimmt das Verriegelungselement nach innen mit. Zu diesem Zweck kann die Innenseite des schraubverstellbaren Rings eine in Umfangsrichtung variierende Dicke aufweisen und sodann beim Übergreifen des Verriegelungselements jenes mit zunehmender Dicke das Eingriffsbereichs nach innen drängen. Der Ring kann auch eine rundum laufende Kante aufweisen, die je nach axialer Verstellung des Rings infolge von dessen Schraubbewegung mehr oder weniger stark mit einen rampenartig anlaufenden Bereich der Außenseite des Verriegelungselements oder eines jenes steuernden Federelements überlappt und dementsprechend dieses mehr oder weniger stark nach innen drückt. Dabei kann ein solches Federelement im Rahmen einer EMV-Maßnahme gleichzeitig als Erdungskontakt dienen.

Es hat sich bewährt, dass die Steckverbindung wenigstens zwei, vorzugsweise drei oder vier Kontakte schließt, wovon zwei den Mess-Stromkreis schließen und der ggf. dritte Kontakt eine Erdungs- und/oder Abschirmungs- und/oder Masseleitung verbindet. Falls ein weiterer Kontakt für eine Erdverbindung vorhanden ist, so ist der Wandler zwar nicht mehr potentialfrei. Jedoch kann dadurch der Stromsensor geerdet werden, wodurch Unfälle oder gar Verletzungen reduziert oder vermieden werden können. In manchen Fällen ist eine Potentialbindung eines Wandlers bzw. dessen einseitige Erdung sogar vorgeschrieben.

Eines der beiden Steckelemente, vorzugsweise das an oder in dem Leistungs- und Multifunktionsmessgerät an- oder eingebaute Steckelement, sollte bevorzugt gegenüber der Gehäusestirnfläche und/oder gegenüber der Stirnfläche des betreffenden, vorzugsweise eingebauten Steckelements, versenkte Kontaktstifte aufweisen. Dies ist beispielsweise dadurch möglich, indem die Kontaktstifte an einer in das Gehäuseinnere verlagerten, inneren oder gar rückwärtigen, zur Steckrichtung quer verlaufenden Fläche festgelegt sind, und/oder indem sie durch einen rundum laufenden Mantel auf ihrer ganzen Länge umgeben werden. Sofern es sich hierbei um das in das Gehäuse des Leistungs- und Multifunktionsmessgerätes eingebaute Steckelement handelt, so steht dabei allein der mechanische Schutz der Kontaktstifte vor Verbiegen oder gar Abbrechen im Vordergrund, weil es sich dabei um einen Eingangsanschluss handelt, der in unbeschaltenem Zustand ja stromlos und spannungsfrei ist. Bei Anordnung auf der Seite des Stromsensors kann damit zusätzlich ein Berührungsschutz realisiert sein, um für das Bedienpersonal einen Kontakt mit spannungsführenden Teilen zu vermeiden. Demgegenüber sollte ein anderes, eher exponiertes und/oder in unverbundenem Zustand möglicherweise spannungführendes Steckelement, vorzugsweise das mit dem Sensor, insbesondere dem Stromsensor, verbundene Steckelement, Kontaktbuchsen aufweisen. In solchen Kontaktbuchsen sind die potentiell spannungführenden Kontakte sehr tief verborgen, so dass kaum eine Gefahr besteht, dass jemand damit in Kontakt kommen könnte.

Es liegt im Rahmen der Erfindung, dass mehrere Steckverbindungen zum

Anschluss je eines Stromsensors vorgesehen sind, d.h. wenigstens Steckverbindungen für Stromsensoren, sodass in einem Drehstromsystem drei Phasenströme gleichzeitig erfasst werden können. Dies ist bei Anlagen der Leistungselektrik, wo Drehstrom zum Einsatz kommt, sehr wichtig, damit das Leistungs- und Multifunktionsmessgerät alle für die Berechnung der Gesamtleistung aller drei Phasen notwendige Informationen erhält. In besonderen Fällen, wenn auch die Nullströme gemessen und nicht nur berechnet werden sollen, kann auch eine vierte Steckverbindung für einen Stromsensor vorgesehen sein.

Das Leistungs- und Multifunktionsmessgerät kann derart gestaltet sein, dass an wenigstens einer Steckverbindung eine Rogowskispule anschließbar ist und/oder ein sonstiger Stromwandler, bspw. eine Stromzange, eine Klappwandler, Aufsteckwandler oder Splitwandler. Rogowskispulen haben gegenüber konventionellen Stromwandlern eine Reihe von Vorteilen, aber auch Nachteile: Rogowskispulen sind einerseits robust und mechanisch flexibel sowie preiswert herstellbar, da kein Eisenkern benötigt wird.

Demzufolge treten Nichtlinearitäten, wie sie durch die magnetische Sättigung von Eisenkernen verursacht sind, bei Rogowskispulen nicht auf. Ferner kann eine Rogowskispule jederzeit ohne Auftrennung des Mess-Stromkreises mechanisch geöffnet werden, bspw. um sie um einen Primärleiter zu schließen. Bei Rogowskispulen gibt es ein weites Band möglicher Nennströme und ein flexibles Wandlerverhältnis und demzufolge sehr unterschiedliche Anwendungsfälle. Mit Rogowskispulen lassen sich derzeit Sröme bis 60.000 A messen, bei einer Durchschlagsfestigkeit von 7,4 kV. Allerdings ist die Amplitude des Ausgangssignals deutlich geringer als die Amplitude eines vergleichbaren Stromwandlers. Daher werden zusätzliche Verstärker benötigt, und zu deren Betrieb ist eine Hilfsenergie notwendig. Die Erfindung empfiehlt daher, im Rahmen eines Mess-Satzes sowohl eine der Anzahl der Stromeingänge des Leistungs- und Multifunktionsmessgerätes entsprechende Anzahl von Stromwandlern vorzusehen als auch eine gleiche Anzahl von Rogowskispulen, um für jede Messanwendung den optimalen Stromsensor zur Verfügung zu haben.

Natürlich kann das Auftrennen des Stromkreises auch zwischen den Messkabeln und dem Stromsensor selbst fatale Folgen haben und sollte daher ebenfalls vermieden werden. Das lässt sich dadurch erreichen, dass ein Verbindungskabel zwischen dem Leistungs- und Multifunktionsmessgerät und einem angeschlossenen Stromsensor auch an dem Stromsensor selbst einrastet. Durch eine formschlüssige Rastverbindung wird ein versehentliches Herausziehen des Kabels bzw. Steckers aus dem Stromsensor vermieden.

Andererseits erfordert eine solche Vorgehensweise, dass das Lösen einer an dem Stromsensor eingerasteten Steckverbindung nur durch Betätigen eines Elements ermöglicht wird, welches dabei jedoch die beiden Strom-Messanschlüsse des Stromsensors kurzschließt. Hierbei handelt es sich um eine mehrfache Sicherheitsmaßnahme: Einerseits wird ein unbeabsichtigtes Lösen der Steckverbindung vermieden, andererseits wird während des Lösevorgangs der betreffende Stromsensor explizit kurzgeschlossen, sodass eine Restspannung entladen wird oder ein Strom durch die Kurzschlussverbindung weiter fließen kann. Nach vollständigem Abtrennen des Leistungs- und Multifunktionsmessgerätes kann durch Loslassen des Betätigungselements der hilfsweise geschlossene Kurzschlussstromkreis gefahrlos geöffnet werden, weil dort nun ggf. induzierte Überspannungen dem abgetrennten Leistungs- und Multifunktionsmessgerät nichts anhaben können. Dies betrifft nur herkömmliche Wandler, spielt jedoch bei Rogowskispulen keine Rolle.

Für den Anschluss je einer Mess-Spannung können mehrere Anschlüsse vorgesehen sein, vorzugsweise zwei, drei, vier oder fünf, um zwei oder drei Phasenspannungen und/oder zwei oder drei verkettete Spannungen gleichzeitig erfassen zu können, sowie vorzugsweise die Spannung eines Sternpunktleiters und/oder die Spannung auf einem Erdungsleiter. Mit dieser Anzahl von Spannungs-Eingängen können alle in einem Drehstromsystem relevanten Spannungen gleichzeitig erfasst und digitalisiert sowie bspw. zur Bestimmung der Drehstromleistung herangezogen werden, insbesondere für eine paarweise Bildung von Spannungsdifferenzen und für eine ansschließende, komponentenweise Multiplikation mit den entsprechenden, ebenfalls digitalisierten Stromwerten.

Damit die zunächst analogen Messwerte von einer arithmetisch-logischen Einheit verarbeitet werden können, müssen sie zuerst digitalisiert werden. Dies leisten Analog-/Digital-Wandler, welche einem oder mehreren Strom- und/oder Spannungseingängen nachgeschalten sind, um für einen für einen Messwert charakteristischen Digitalwert zu erzeugen. Um für einen solchen Wandlungsvorgang optimale Voraussetzungen zu erhalten, kann einem solchen Analog-/Digital-Wandler jeweils wenigstens ein Abtast- und Halteglied vorgeschalten sein, welches beispielsweise in einem bestimmten Zeitraster immer einen Funktionswert entnimmt und bis zur nächsten Entnahme konstant hält, sodass ein nachgeordneter Analog-/Digitalwandler ohne Zeitnot alle Digits bis zum niederwertigsten Bit bestimmen kann.

Bevorzugt wird in dem Leistungs- und Multifunktionsmessgerät wenigstens je ein digitaler Strom- und Spannungs-Messwert miteinander multiplikativ verknüpft, um auf diesem Weg einen Leistungswert zu bestimmen. Je nachdem, ob ein Leistungswert aus einer Gleichspannung, einer Wechselspannung oder aus einem Drehstromsystem bestimmt werden soll, können hierfür verschiedene Algorithmen zum Einsatz kommen. Das Leistungs- und Multifunktionsmessgerät sollte daher programmierbar sein, um es dem jeweiligen Einsatzfall optimal anpassen zu können. Bei einem programmierbaren Leistungs- und Multifunktionsmessgerät sind auch weitere logische und/oder mathematische Funktionen möglich, z.B. die Bestimmung von Mittelwerten, Minimal- und Maximalwerten, Effektivwerten, Grenzwerten, etc.

Die Erfindung lässt sich dahingehend weiterbilden, dass die multiplikative Verknüpfung zwischen wenigstens je einem digitalen Strom- und SpannungsMesswert von einer in dem Leistungs- und Multifunktionsmessgerät integrierten arithmetisch-logischen Einheit ausgeführt wird. Je nach der benötigten Rechenleistung kann es sich hierbei um einen Controller oder ein Lokikmodul bzw. eine SPS oder einen Prozessor oder einen mathematsichen Prozessor oder um ein System mit mehreren Kernen handeln. Die Einbindung einer SPS bzw. eines Logikmoduls wird bevorzugt mittels eines Bus realisiert, bspw. einem Modbus-TCP, Modbus-RTU, KNX, Canbus, ASIbus, Profibus, MPI-Bus, oder einer anderen Busart.

Durch eine Anzeigeeinrichtung wird das erfindungsgemäße Leistungs- und Multifunktionsmessgerät einerseits befähigt, einen ermittelten Leistungswert oder sonstige Daten unmittelbar anzuzeigen. Dies kann in Form einer Zahl erfolgen oder als Grafik. Darüber hinaus lassen sich an einem solchen, alphanumerischen oder gar graphischen Anzeigeelement (Display) weitere Informationen darstellen, bspw. Programmparameter, etc.

Die periphere elektronische Beschaltung einer arithmetisch-logischen Recheneinheit kann wenigstens einen Datenspeicher umfassen zur Speicherung oder Zwischenspeicherung gemessener elektrischer Größen, ermittelter Leistungswerte und/oder sonstiger Parameter. Dadurch lässt sich das erfindungsgemäße Leistungs- und Multifunktionsmessgerät in einem Modus betreiben ähnlich einem sog. Datalogger, d.h., die Daten müssen nicht sofort ausgewertet werden, sondern werden in einem Datenspeicher abgelegt für eine spätere Auswertung, bspw. für eine Netzanalyse oder einen Report nach DIN ISO 50001 oder EN 50160. Falls für eine große Datenmenge ausreichende Speicherkapazität benötigt wird, kann als Datenspeicher für die Mess- und/oder Rechenwerte auch eine Festplatte oder ein Solid-State-Drive (SSD, Halbleiterlaufwerk) dienen.

Als weitere Konstruktionsvorschrift sollte wenigstens eine Datenschnittstelle vorgesehen werden, um ermittelte Leistungswerte an einen entfernten Ort, bspw. einen zentralen Server, übertragen zu können, bspw. nach Art eines entfernten Webservers. Somit lässt sich die Auswertung der gewonnenen Daten auf einem anderen Rechner durchführen, und/oder die Daten können zentral archiviert werden oder einem Spezialisten zur Verfügung gestellt werden. Als Datenschnittstelle kommt sowohl eine kabelgebundene Schnittstelle in Betracht wie ein Anschluss für eine Ethernet-Verbindung oder LAN oder ein sonstiger Bus oder für eine USB-Verbindung, als auch eine kabellose Schnittstelle, insbesondere per Funk wie WLAN, WiFi oder Bluetooth, aber auch eine Infrarotschnittstelle wäre grundsätzlich denkbar.

Weiterhin entspricht es der Lehre, dass Daten von/zu dem Leistungs- und Multifunktionsmessgerät über eine geräteseitige Antenne übertragbar sind. Damit lässt sich eine Funkverbindung aufbauen, sodass ein unmittelbarer Datenfluss auch von entlegeneren Einsatzorten aufrecht erhalten werden kann, beispielsweise vom Außenbereich eines umfangreichen Solarfeldes, wobei Rückmeldungen über Fehlfunktionen od. dgl. quasi in Echtzeit an eine Zentrale übermittelt werden können und dort zur Auslösung eines Alarms oder einer sonstigen Reaktion herangezogen werden können. Über eine Funkverbindung können auch später zu jeder beliebigen Zeit Datenabfragen erfolgen. Insbesondere können sodann auch während einer Auswertung an einem entfernten Ort dort benötigte Zusatzinformationen aus dem in dem Leistungs- und Multifunktionsgerät enthaltenen Speicherglied per Fernabfrage ausgelesen werden.

Ferner zeichnet sich das Leistungsmessgerät aus durch ein oder mehrere, steuerbare Ausgänge, vorzugsweise Digital-Ausgänge. Durch derartige Schaltausgänge oder auch durch steuerbare Analogausgänge wird das erfindungsgemäße Leistungs- und Multifunktionsmessgerät in die Lage versetzt, selbst steuernd oder regelnd auf eine Anlage einzuwirken, indem es anhand der gemessenen und/oder berechneten Daten nach bestimmten Algorithmen Ausgangssignale erzeugt, die mit der Anlage schaltungstechnisch gekopellt sind. Beispielsweise könnten bei Überkapazitäten einer Solaranlage Elektrospeicher zugeschalten werden, oder bei einer Fehlfunktion könnte der betreffende Anlagenzweig vom Rest abgetrennt werden, etc., bzw. können Lastschaltungen vorgenommen werden, um in einem Industriebetrieb Lastspitzen zu vermeiden.

Ein weiterer, vorteilhafter Gesichtspunkt ist, dass das tragbare Leistungs- und Multifunktionsmessgerät Bestandteil einer Anlagensteuerung sein kann, insbesondere einer speicherprogrammierbaren Steuerung, und ein oder mehrere Funktionen der Anlagensteuerung oder speicherprogrammierbaren Steuerung übernimmt.

Dies resultiert vor allem auch aus der Tatsache, dass das erfindungsgemäße Leistungs- und Multifunktionsmessgerät dank des Einsatzes einer oder mehrerer Rogowskispulen und/oder Halleffektsensoren und/oder Shunts weitaus störungsärmer arbeitet als bei Verwendung von Stromwandlern, und deshalb im Rahmen einer Anlagensteuerung kaum oder nicht zu Störungen führt.

Eine Anlagensteuerung umfasst im Wesentlichen die folgenden Komponenten:
Einen oder mehrere Sensoren, welche Parameter der Anlage erfassen und für die weitere Verarbeitung aufbereiten, bspw. in ein elektrisches Signal umwandeln;
wenigstens eine Arithmetisch-logische Einheit oder Recheneinheit welche mit analogen und/oder digitalen Eingängen kommuniziert, um von dort Informationen über die Anlage zu erhalten, insbesondere mittels Sensoren gewonnene Informationen, und die aus den dadurch erhaltenen Informationen Steuersignale erzeugt, welche auf die Anlage einwirken sollen und über analoge und/oder digitale Eingänge ausgegeben werden;
sowie einen oder mehrere Aktuatoren, welche anhand der von der arithmetisch-logische Einheit oder Recheneinheit generierten Steuersignale auf bestimmte Stellgrößen der Anlage einwirken und dadurch die Betriebsparameter der Anlage in gewünschten Bereichen zu halten.

Ferner gibt es noch wenigstens einen Speicher, insbesondere einen Programmspeicher, wo das Programm, nach welchem die Anlagensteuerung arbeitet, hinterlegt ist.

Ein weiterer, bevorzugter Bestandteil einer solchen Anlagensteuerung ist eine Schnittstelle, insbesondere eine Programmierschnittstelle, an welcher das Programm in die Steuerung geladen werden kann, und wo auf das Programm der Anlagensteuerung bspw. korrigierend eingewirkt werden kann.

Das erfindungsgemäße, tragbare Leistungs- und Multifunktionsmessgerät kann einen oder mehrere dieser Bestandteile der Anlagensteuerung ergänzen oder ersetzen.

Insbesondere kann es eine intelligente Schnittstelle zwischen (Strom- oder Spannungs-) Sensoren und der Auswerte- oder Recheneinheit bilden, wo eine Vorauswertung stattfinden kann, bspw. die Berechnung einer Leistung od. dgl., die dann bspw. als digitaler Datenwert über eine Digitalschnittstelle an eine externe logisch-arithmetische Auswerteeinheit oder Recheneinheit, insbesondere einer Speicherprogrammierbaren Steuerung, übertragen werden kann.

Ferner kann das erfindungsgemäße, tragbare Leistungs- und Multifunktionsmessgerät die arithmetisch-logische Einheit bzw. Steuer- oder Recheneinheit ergänzen oder ersetzen, indem digitale und/oder analoge Ausgänge vorgesehen sind, wo die berechneten oder gemäß sonstiger Algorithmen ermittelten Steuersignale ausgegeben werden, um über angeschlossene Aktuatoren auf die betreffende Anlage einzuwirken.

Im Rahmen dieser Funktionalität als arithmetisch-logische Einheit einer Anlagensteuerung kann das erfindungsgemäße Multifunktionsmessgerät verschiedene Aufgaben erfüllen:
Die Kernaufgabe der arithmetisch-logischen Einheit einer Anlagensteuerung ist es, in eine Maschine oder eine Anlage steuernd einzugreifen. Dazu muss sie eine programmierbare Relation zwischen den digitalen und/oder analogen Ein- und Ausgängen herstellen.

Als Eingänge sind bei dem erfindungsgemäßen Leistungs- und Multifunktionsmessgerät ja bereits Strom- und Spannungseingänge vorhanden. Es kann dazu noch weitere Eingänge geben, bspw. logische Eingänge, welche zwischen einem Low- und einem High-Pegel unterscheiden können, Bus-Eingänge, wo ganze Datenworte eingelesen werden können, oder analoge Eingänge, wo weitere Sensoren angeschlossen sein können. Bevorzugt ist einem derartigen Analogeingang ein Analog-Digital-Wandler nachgeschalten, um die ankommenden Analogsignale für eine digitale Weiterverarbeitung in eine zu der momentanen Amplitude des Analogsignals proportionales Datenwort umzuwandeln.

Auf die solchermaßen gewonnenen digitalen Daten wendet die arithmetisch-logische Einheit sodann den jeweils einprogammierten Steuer-Algorthums an, der je nach Anforderung relativ einfach, aber auch durchaus komplex sein kann.

Das Spektrum der Programm-Algorithmen reicht von logischen Verküpfungen, Zählen von Impulsen, Triggern von Ereignissen, über Vergleiche von Mess- oder sonstigen Signalen mit Grenzwerten bis hin zu mathematischen Berechnungen. Letztere wiederum können Additionen und/oder Subtraktionen sein, ferner Multiplikationen und/oder Divisionen, oder auch nichtlineare Funktionen, z.B. Quadrieren oder Wurzelziehen.

Als programmierbare Rechen-Algorithmen können ferner Interpolationen durchgeführt werden, auch Ableitungen und/oder Integrationen.

Noch komplexere Funktionen können bspw. Verzögerungen wie Totzeiten sein und/oder Regelungen, z.B. Zweipunktregler, Proportionalregler, Integralregler, PID-Regler, etc. Dabei könnte sogar - abhängig von bestimmten Parametern - die Reglerstruktur dynamisch angepasst werden, bspw. durch Um- oder Aufschaltung von Signalen, etc.

Das Ziel derartiger Manipulationen ist, ein oder mehrere geeignete Steuersignale zu erzeugen, welche dann über Ausgänge an dafür vorgesehene Aktuatoren weitergeleitet werden.

Neben dem Steuern oder Regeln einer Maschine oder Anlage kann eine weitere Aufgabe darin bestehen, Signalgeber anzusteuern, bspw. Warn- oder Kontrolllampen, Hupen, Sirenen, etc.

Darüber hinaus kann ein erfindungsgemäßes Leistungs- und Multifunktionsmessgerät derart programmiert werden, um Maschinen- oder Anlagenparameter oder sonstige Messwerte zu visualisieren, bspw. auf einem Bildschirm.

Eine weitere Aufgabe kann ein erfindungsgemäßes Leistungs- und Multifunktionsgerät erfüllen, nämlcih die Dokumentation. Dazu können bspw. bestimmte Ereignisse abgespeichert werden, und/oder Mess- oder Parameterwerte werden chronologisch aufgezichnet.

Bei Bedarf können solche Daten dann weiter übertragen werden, bspw. über ein Bus-System oder über eine serielle Leitung, oder per Datenträger. Auch ein Ausdrucken ist dadurch möglich.

Weitere Merkmale, Einzelheiten, Vorteile und Wirkungen auf der Basis der Erfindung ergeben sich aus der folgenden Beschreibung einer bevorzugten Ausführungsform der Erfindung sowie anhand der Zeichnung. Hierbei zeigt:
- Fig. 1: ein erfindungsgemäßes, tragbares Leistungs- und Multifunktionsmessgerät in einer perspektivischen Ansicht schräg von vorne;
- Fig. 2: eine rückwärtige Ansicht des Leistungs- und Multifunktionsmessgerätes nach Fig. 1;
- Fig. 3: ein Stecker mit mehreren Kontakten zum Anschluss eines Stromsensors gleich welcher Art an das Leistungs- und Multifunktionsmessgerät nach Fig. 1;
- Fig. 4: eine vollständige Steckverbindung für einen Stromsensor, umfassend eine Einbaubuchse mit versenkten Kontaktstiften und einen in die Einbaubuchse einführbaren Stecker mit mehreren, je ein Kontaktstift aufnehmenden Steck-Ausnehmungen in der freien Stirnseite;
- Fig. 5: einen an das Leitungs- und Multifunktionsmessgerät nach Fig. 1 anschließbaren Stromwandler in Form eines Klappwandlers in einer perspektivischen Ansicht;
- Fig. 6: ein Ersatzschaltbild für den Stromwandler nach Fig. 5;
- Fig. 7: ein der Fig. 6 entsprechendes, jedoch abgewandeltes Ersatzschaltbild für einen anderen Stromwandler;
- Fig. 8: eine an das Leistungs- und Multifunktionsmessgerät nach Fig. 1 anschließbare Rogowskispule in der Seitenansicht;
- Fig. 9: einen Schnitt durch die Rogowskispule nach Fig. 8 längs einer von der Rogowskispule aufgespannten Ebene, wobei eine beispielhafte Beschaltung der Rogowskispule deutlicher hervorgehoben ist;
- Fig. 10: eine abgewandelte Bauform eines erfindungsgemäßen Leistungs- und Multifunktionsmessgerätes in einer der Fig. 1 entsprechenden Ansicht, wobei besonderes Gewicht auf einen robusten Aufbau gelegt ist.

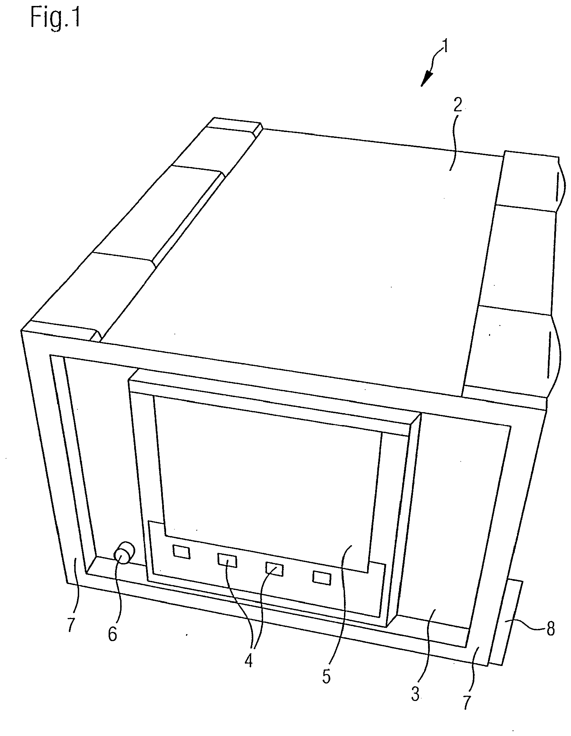

In Fig. 1 ist der kompakte Aufbau eines erfindungsgemäßen, tragbaren Leistungs- und Multifunktionsmessgerätes 1 gut sichtbar. Man erkennt ein Gehäuse 2 mit einem etwa quaderförmigen Aufbau, in dessen Vorderseite 3 ein mit Tasten 4, beisspielsweise mit flachen Druckknopf-Tasten 4, bedienbares, optisches Anzeigeelement 5 eingebaut ist.

Mit diesem optischen Anzeigeelement 5 kann eine arithmetisch-logische Einheit zu einer Baueinheit integriert sein, welche die eigentlichen Leistungsberechnungen ausführt, und die ggf. weitere Aufgaben wie bspw. Grenzwertbildung, etc., übernimmt.

Für den Fall, dass die arithmetisch-logische Einheit nicht mehr reagiert, kann ein Rücksetzknopf 6 vorgesehen sein.

An dem Gehäuse 2 befindet nahe jeder Ecke 7 je ein Standfuß 8. Insbesondere die beiden vorderen Standfüße 8 können nach unten herabschwenkbar oder ausschiebbar ausgebildet sein, um die Vorderseite 3 des Gehäuses mit dem Anzeigeelement 5 zu dessen besserer Lesbarkeit anheben zu können.

Ferner kann ein oberseitiger Tragegriff vorgesehen sein oder ein Tragebügel, der vorzugsweise nach unten wegschwenkbar ist.

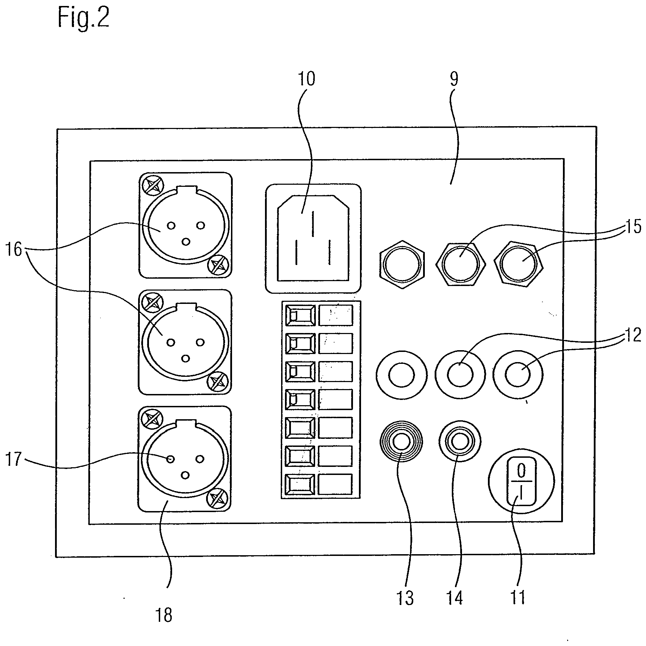

Die Anschlüsse des Leistungs- und Multifunktionsmessgerätes 1 befinden sich bei dieser Ausführungsform an dessen Rückseite 9, die in Fig. 2 zu sehen ist.

Zur Stromversorgung ist eine Kaltgeräte-Einbaubuchse 10, ggf. mit integrierter Feinsicherung und/oder Netzschalter, vorgesehen, worin ein Netzkabel mit einem passenden Pendant eingesteckt werden kann. Zur Versorgung der Elektronik ist innerhalb des Gehäuses 2 ein Netzteil vorgesehen, um aus der Wechselspannung eine konstante Gleichspannung für die integrierte (Zusatz-) Elektronik zu erzeugen. Optional kann auch eine unterbrechungsfreie Stromversorgung (USV) integriert werden, welche dann in der Lage ist, bei einem Netzausfall die Spannungsversorgung zumindest für ein gewisses Zeitintervall aufrecht zu erhalten. Damit ließen sich dann auch Stromausfälle aufzeichnen.

Mit einem Netzschalter 11 kann das Leistungsm- und Multifunktionsmessgerät 1 ein- und ausgeschaltet werden, welcher wahlweise einzeln oder in der Kaltgeräte-Einbaubuchse 10 integriert sein kann.

Für den Anschluss von Spannungsabgriffen sind drei einpolige Spannungseingänge 12 vorhanden, beispielsweise für die drei Phasenspannungen eines Drehstromnetzes, sowie ein Eingang 13 für den Sternpunktleiter oder Neutralleiter, und ein Erdungsspannungs-Eingang 14. An diesen Spannungseingängen 12 kann auch eine Spannungsversorgung für die in dem Leistungs- und Multifunktionsmessgerät 1 integrierte Elektronik abgegriffen werden.

Durch die Bildung der Summe aus allen Strömen eines Drehstromnetzes, insbesondere der Ströme in den Außen- oder Phasenleitern, oder durch Messung des Stroms im Erdleiter, lässt sich die Funktion eines Fehlerstromschutzschalters (FI-Schalters) nachbilden. Dabei lassen sich sogar in der für FI-Schutzschalter gültigen DIN-Norm normierte Abschaltzeiten (mit einer Verzögerung eines realen FI-Schalters) oder Toleranzen modellieren bzw. programmieren, um teure FI-Leistungsschalter zu ersetzen, oder um die Schaltcharakterisitk auf einen gewünschten Fall individuell einzustellen. Damit ließe sich z.B. ein Dauerbetrieb nahe des Nennstroms ermöglichen, wobei dank einer gesteigerten Toleranz dann Fehlauslösungen vermieden werden können. Auch ist es möglich, bei Bedarf einen vorübergehenden Betrieb einer Anlage ohne einen physisch real vorhandenen FI-Schutzschalter aufrechtzuerhalten.

Zum Durchführen einer Abschaltung kann an einem Digitalausgang des Leistungs- und Multifunktionsmessgeräts 1 ein Lastschalter bzw. Hauptschalter angeschlossen sein, welcher hohe Lasten schalten kann, bspw. mit einem integrierten Antrieb oder Signalauslöser. Damit lässt sich dann im Falle der Erkennung eines Leckagestroms die Last abtrennen.

Mit Sicherungen 15 können einzelne Phasenspannungen abgesichert werden, insbesondere wenn eine davon zur Spannungsversorgung verwendet wird.

Darüber hinaus verfügt das Leistungs- und Multifunktionsmessgerät 1 über drei Anschlüsse 16 für den Anschluss je eines Stromsensors. Jeder dieser Anschlüsse kann jeweils zwei oder vorzugsweise drei Kontakte 17 umfassen, von denen dann zwei Kontakte 17 zum Schließen des eigentlichen Mess-Stromkreises dienen und der dritte Kontakt 17 beispielsweise als zusätzlicher Erdungskontakt dienen kann. Ferner kann als EMV-Maßnahme das Gehäuse zur Abschirmung verwendet werden.

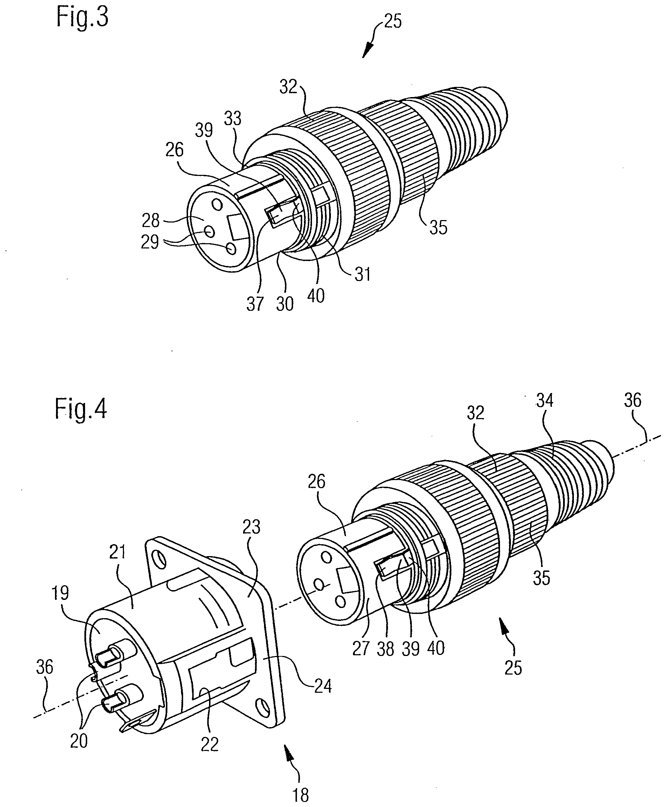

In Fig. 4 ist links ein dreipoliger Anschluss 16 gemäß Fig. 2 für den Anschluss eines Stromsensors dargestellt, in einer Perspektive schräg von hinten. Es handelt sich hierbei um eine dreipolige Einbau-Buchse 18, an deren Rückseite 19 mehrere Lötanschlüsse 20 zu erkennen sind.

Ferner ist ein zylindrischer Mantel 21 erkennbar, vorzugsweise aus Metall, welcher die Einbau-Buchse 18 außen umgibt und abschirmt; in diesem zylindrischen Mantel 21 befindet sich eine seitliche, schlitzförmige Öffnung 22, die sich bis zu einem vorderseitigen Befestigungsflansch 23 erstreckt. Diese schlitzförmige Öffnung 22 wird jedoch von einem brückenförmigen Teil 24 am Rande des Befestigungsflansches 23 überbrückt.

Das Pendant zu einer solchen Einbau-Buchse 18 bildet ein passender Stecker 25, der in Fig. 3 einzeln sowie in Fig. 4 in einer Flucht mit der dortigen EinbauBuchse 18 wiedergegeben ist. Man erkennt einen in die Einbau-Buchse 18 einsteckbaren Vorsprung 26 mit einem zylindrischen Mantel 27, welcher vorzugsweise aus Metall besteht, während die Stirnseite 28 des Vorsprungs 26 bevorzugt aus nicht leitendem Kunststoff ausgeführt ist. In dieser Stirnseite 28 (siehe Fig. 3) befinden sich mehrere Öffnungen 29 - vorzugsweise zwei oder drei, worin jeweils wenigstens ein Kontaktmittel zur Kontaktierung des betreffenden Kontaktstiftes in der Einbau-Buchse 18 angeordnet ist; diese Kontaktmittel - wie auch die Kontaktstifte 17 - können aus verschiedenen, elektrisch leitenden Materialien bestehen wie Kupfer, Messing, Gold, Silber, Zinn, oder sie können mit einem solchen, gut leitenden Material überzogen sein.

Wie man aus Fig. 4 entnehmen kann, befindet sich auch in dem zylindrischen Mantel 27 des einzusteckenden Vorsprungs 26 an dem Stecker 25 eine schlitzförmige Öffnung 30, die jedoch ebenfalls nicht bis an die vordere, freie Stirnseite 28 des Vorsprungs 26 heranreicht, sondern davor endet.

Diese schlitzförmige Öffnung 30 reicht andererseits bis zu einem außenseitig an dem Stecker 25 umlaufend angeordneten Gewinde 31 heran, welches dem Aufschrauben eines mit einem Innengewinde versehenen Rings 32 dient, und die schlitzförmige Öffnung 30 erstreckt sich sogar teilweise in dieses Gewinde 31 hinein, und wird zwischen dem Mantel 27 und dem Gewinde 31 von einem den Stecker 25 umlaufenden Dichtungsring 33 übergriffen.

Am rückwärtigen Ende des Steckers 25 befindet sich eine Tülle 34 als Führung für ein nicht dargestelltes Kabel, welches zum eigentlichen Stromsensor führt. Diese Tülle 34 ist an einem mit Innengewinde versehenen Ring 35 gehalten, der rückwärtig auf den Stecker 25 aufschraubbar ist. Durch das Aufschrauben dieses Tüllen-Rings 35 werden innenliegende Klemmbacken entlang der konischen Innenseite der Tülle 34 zueinander geführt und klemmen dabei das eigentliche Kabel nach Art einer Zugentlastung fest.

Die Besonderheit eines solchen Steckers 25 ist, dass in der mantelseitigen, schlitzförmigen Öffnung 30 ein radial zu der Achse 36 der Steckrichtung verstellbares Verriegelungselement 37 geführt oder gelagert ist.

Dieses Verriegelungseleement 37 wirkt zusammen mit dem brückenförmigen Element 24, welches die schlitzförmige Öffnung 22 in dem zylindrischen Mantel 21 der Einbau-Buchse 18 übergreift. Zu diesem Zweck ist die radial außen liegende Seite 38 des Verriegelungselements 37 hinter einer von vorne nach hinten sanft auskragenden, rampenartigen Anlauffläche 39 als zurückspringende Hakennase 40 ausgebildet. Beim Einstecken des Steckers 25 in die Einbau-Buchse 18 wird das Verriegelungselement 37 zunächst nach innen gedrückt, weil das brückenförmige Element 24 der Einbau-Buchse 18 an der rampenartigen Anlauffläche 39 entlangläuft und jene zusammen mit dem gesamten Verriegelungselement 37 zum Zurückweichen zwingt. Hat das brückenförmige Element 24 dabei den am weitesten vorspringenden Teil des Verriegelungselments 37 im Bereich von dessen Hakennase 40 überschritten, federt das Verriegelungselement 37 wieder nach außen, wobei die Hakennase 40 das brückenförmige Element 24 der Einbau-Buchse 18 hintergreift. Nun ist der Stecker 25 formschlüssig mit der Einbau-Buchse 18 verriegelt und kann sich von selbst nicht mehr lösen.

Ein Lösen des Steckers 25 von der Einbau-Buchse 18 ist vielmehr nur dadurch möglich, dass der Ring 32 gegenüber seinem Gewinde 31 geschraubt wird, insbesondere entgegen der Steckrichtung weg von der Einbau-Buchse 18. Dabei wird das Verriegelungselement 37 radial nach innen gedrückt und kommt dadurch von dem brückenförmigen Element 24 der Einbau-Buchse 18 frei.

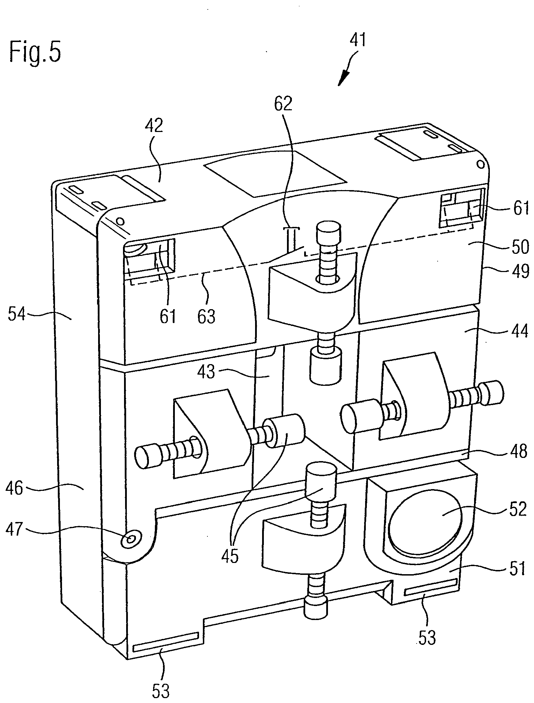

Somit ist eine Möglichkeit geschaffen, wie eine Steckverbindung für einen Stromsensor an dem erfindungsgemäßen Leistungs- und Multifunktionsmessgerät 1 zwar bei Bedarf jederzeit geöffnet und dadurch der Stromkreis geöffnet werden kann, ohne dass dabei überhöhte Spannungsspitzen induziert werden können, welche dann für jede betroffene Elektronikschaltung eine Gefahr darstellen, während ein unbeabsichtigtes Öffnen des Stromkreises an dieser Stelle ausgeschlossen ist. Allerdings könnte der Stromkreis auch an einer anderen Stelle aufgetrennt werden, insbesondere im Bereich des Stromsensors selbst, vor allem dort, wo die Messkabel an jenem Stromsensor angeschlossen sind. Auch dort lassen sich Vorkehrungen gegen ein unbeabsichtigtes Auftrennen des Stromkreises treffen, wie im folgenden anhand eines Klappstromwandlers 41 veranschaulicht werden soll, wie er in Fig. 5 in einer perspektivischen Ansicht dargestellt ist.

Wie man der Fig. 5 entnehmen kann, hat der Klappstromwandler 41 etwa eine ringförmige Struktur nach Art eines aufrecht stehenden, rechteckigen Rahmens 42, der eine etwa mittige, im Vertikalschnitt rechteckige Durchbrechung 43 umgibt. Durch diese Durchstecköffnung oder Durchbrechung 43 kann ein stromdurchflossener Primärstromleiter, dessen Strom gemessen werden soll, hindurchgesteckt werden. An einer Flachseite 44 des etwa scheibenförmigen Klappstromwandles 41 ragen von dem Rahmen 42 aus unterschiedlichen Richtungen mehrere abgefederte Druckelemente 45 in die Durchbrechung 43 hinein oder befinden sich unmittelbar vor jener. Die Aufgabe dieser Druckelemente 45 besteht darin, einen durch die Öffnung 43 gesteckten Primärstromleiter etwa zentrisch innerhalb dieser Öffnung 43 zu halten.

Man erkennt im Bereich einer seitlichen Stirnseite 46 des Klappstromwandlers 41 - in Fig. 5 links - ein Scharnier 47, dessen Scharnierachse die Scheibenform des Klappstromwandlers 1 etwa lotrecht durchsetzt. Etwa auf Höhe dieses Scharniers 47 erstreckt sich ein Spalt 48 bis zu der Durchbrechung 43 und setzt sich jenseits derselben bis zu der gegenüberliegenden Stirnseite 49 des Klappstromwandles 41 fort. Dieser Spalt 48 erlaubt das Hochschwenken des oberen Teils 50 des Klappstromwandlers 41 gegenüber dessen unterem Teil 51, um die Achse des Scharniers 47.

Dabei öffnet sich die Durchbrechung 43 längs des Schlitzes 48 bis zu der dem Scharnier 47 abgewandten Stirnseite 49 des Klappstromwandlers 41 hin, und von dort kann dann ein Primärstromleiter in die Durchbrechung 43 eingelegt werden.

Nach dem Einlegen eines Primärstromleiters wird das obere Teil 50 des Klappstromwandlers 41 wieder auf dessen unteres Teil 51 herabgeklappt. In diesem Zustand rastet ein interner Rastmechanismus ein und hält beide Teile 50, 51 aneinander fest, der Spalt 48 bleibt geschlossen und kann erst wieder geöffnet werden, wenn eine Entriegelungstaste 52 gedrückt wird, welche den internen Rastmechanismus löst.

Der Klappstromwandler 41 steht auf Standfüßen 53 an der Unterseite des unteren Teils 51.

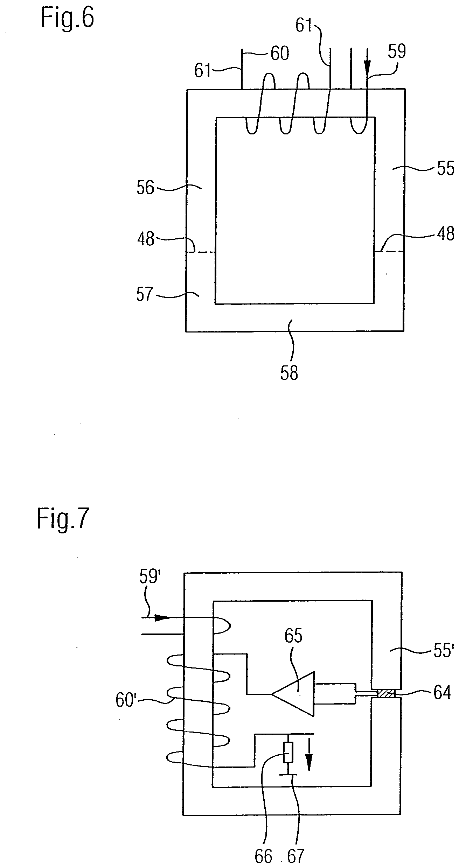

Der innere Aufbau des Klappstromwandlers 41 ist in Fig. 6 wiedergegeben. Man sieht dort, dass sich innerhalb des Gehäuses 54 des Klappstromwandlers 41 ein magnetischer oder magnetisierbarer Kern 55 befindet, vorzugsweise aus Eisen, welcher ringförmig zu einer rechteckigen Rahmenstruktur geschlossen ist, sobald das obere Teil 50 auf das untere Teil 51 herabgeklappt ist. Man erkennt dabei in Fig. 6 als gestrichelte Linie den Schlitz 48, welcher den Kern 55 in ein oberes Kern-Teil 56 und in ein unteres Kern-Teil 57 unterteilt.

Sobald durch den die Durchbrechung 43 des Klappstromwandlers und somit auch die Ausnehmung 58 innerhalb des (Eisen-) Kerns 55 durchsetzenden Primärstromleiter 59 ein Strom fließt, wird dieser Primärstromleiter 59 von einem Magnetfeld ringförmig umgeben. Dieses Magnetfeld erzeugt innerhalb des Kerns 55 einen magnetischen Fluss, und dessen Änderung wiederum induziert in einer um den Kern 55 gewickelten Sekundärspule 60 eine Spannung, welche schließlich bei geschlossenem Sekundärstromkreis zu einem Sekundärstrom führt, der dann durch ein angeschlossenes Kabel und über den betreffenden Strom-Anschluss 16 zu dem Leistungs- und Multifunktionsmessgerät 1 fließt, wo er beispielsweise an einem Shunt einen zu dem sekundären Mess-Stromfluss proportionalen Spannungsabfall hervorruft. Dieser kann schließlich abgetastet und in kurzen Zeitabständen in Digitalwerte umgewandelt werden. Man erhält somit im Leistungs- und Multifunktionsmessgerät 1 eine Folge von digitalisierten Strommesswerten für die weitere Auswertung, insbesondere für die Multiplikation mit einem zugeordneten Spannungsmesswert.

Während einer Messung bzw. solange ein Primärstrom eine Spannung innerhalb der Sekundärspule 60 induziert und damit einen sekundären Stromfluss zur Folge hat, sollte der Stromkreis durch das Verbindungskabel zwischen dem Klappstromwandler 41 und dem Leistungs- und Multifunktionsmessgerät 1 weder absichtlich noch versehentlich aufgetrennt werden. Denn in diesem Fall kann der plötzliche Stromabbruch eine extrem hohe Spannungsspitze zur Folge haben, die verschiedene Bestandteile der Anordnung, insbesondere den Klappwandler 41, aber auch die Elektronik innerhalb des Leistungs- und Multifunktionsmessgerätes 1, zerstören könnte.

Als zusätzliche Sicherheit hat der Erfinder in den Sekundärstromkreis eine Mechanik eingebaut, die beim Schließen eines Kurzschlussschalters 62 vor dem Öffnen des Kontakts zu dem betreffenden Leitungsansschluss zunächst eine leitende Verbindung 63 zu dem anderen Anschluss 61 der Sekundärspule herstellt, quasi als Bypass zu dem aufzutrennenden Meß-Stromkreis. Damit kann sich der Stromkreis der Sekundärspule 60 vorübergehend über eine parallele Leitung 63 schließen, und das Auftrennen der dann stromlosen Kabelverbindung zu dem Leistungs- und Multifunktionsmessgerät 1 führt nicht zu einer gefährlichen Spannungsspitze.

In Fig. 7 ist ein alternativer elektrischer Aufbau eines Klappstromwandler 41' wiedergegeben.

Der größte Unterschied besteht darin, dass dort - beispielsweise im Bereich des Spaltes 48, welcher den oberen Teil 50 des Kerns 55 von dessen unterem Teil 51 trennt - ein Hallsensor 64 eingebaut ist, von welchem eine Spannung abgegeben wird, sobald der Hallsensor 64 einem Magnetfeld ausgesetzt ist. Die Ausgangsspannung des Hallsensors 64 wird verstärkt, beispielsweise von einem Operationsverstärker 65, und speist sodann die Sekundärspule 60', die an ihrem gegenüber liegenden Ende über einen Widerstand 66 an Masse 67 gelegt ist. Daher fällt an dem Widerstand 66 auch eine Spannung ab, sobald nur ein reiner Gleichstrom durch den Primärstromleiter 59' fließt und einen zeitlich konstanten Magnetfluss durch den Kern 55' hervorruft. Im Allgemeinen befindet sich der Widerstand 66 in dem Leistungs- und Multifunktionsmessgerät 1, so dass auch bei dieser Anordnung der Stromkreis nicht während einer Messung aufgetrennt werden darf.

Im Gegensatz zu der Mess-Anordnung eines Klappstromwandlers 41 nach Fig. 6 ist die Mess-Anordnung eines Klappstromwandlers 41' nach Fig. 7 daher sogar in der Lage, einen konstanten Gleichstrom zu erkennen.

Die erfindungsgemäße Methode, die Kontakte 61 der Sekundärspule 60 vor dem Entriegeln der Steckbuchsen durch einen Kurzschlussschalter miteinander zu verbinden, lässt sich auf die unterschiedlichsten Stromsensoren übertragen, beispielsweise auch auf Messtransformatoren, etc.

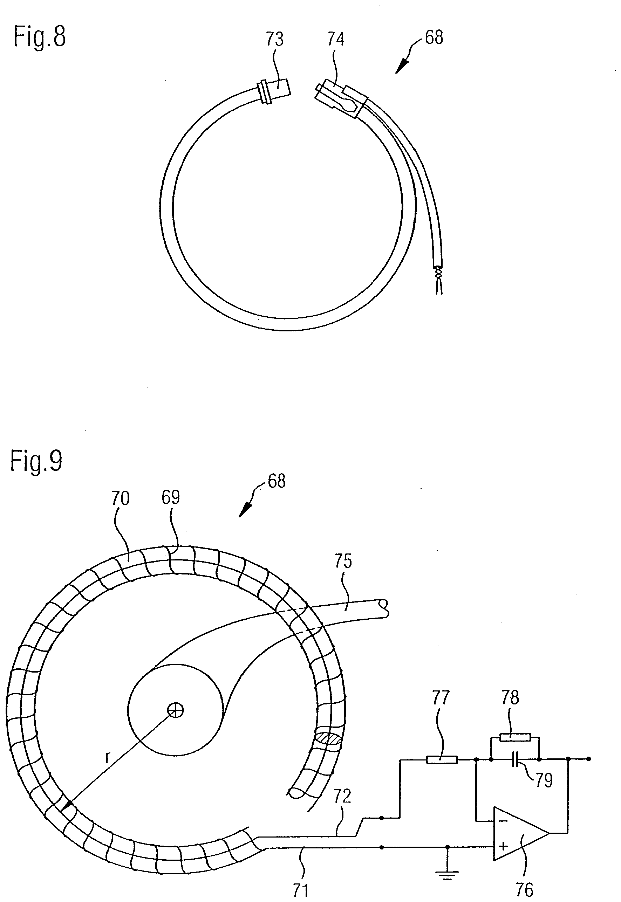

Ein weiterer solcher Stromsensor, der sich für die Verwendung in Verbindung mit dem erfindungsgemäßen Leistungs- und Multifunktionsmessgerät 1 eignet, ist die sogenannte Rogowskispule 68 nach Fig. 8. Es handelt sich hierbei um eine toroidförmige Luftspule ohne einen ferromagnetischen Kern. Wie man dem elektrischen Ersatzschaltbild einer Rogowskispule 68 gemäß Fig. 9 entnehmen kann, ist ein Leiterdraht 69 dazu möglichst gleichmäßig um einen toroidförmigen Körper 70 gewickelt, wobei der torodförmige Körper 70 nicht aus einem ferromagnetischen Material besteht, sondern z. B. auch aus einem elastischen Material wie Kunststoff gefertigt sein kann.

Zwar liegen die beiden Enden 71, 72 des als Luftspule aufgewickelten Leiterdrahts 69 eng beieinander, so dass sie unmittelbar von der Rogowskispule 68 weg geführt werden könnten. Dennoch wird bevorzugt ein Ende 72 des Leiterdrahts 69 innerhalb oder neben dem toroidförmigen Körper 70 der Rogowskispule 68 zu dem anderen Ende 71 zurückgeführt. Dies hat den Vorteil, dass eine solche Rogowskispule 68 nicht vollkommen geschlossen ist, sondern an einer Stelle unterbrochen ist, wie man in Fig. 8 besonders deutlich erkennen kann. Dort befinden sich nur zwei zusammensteckbare und voneinander lösbare Verbindungselemente 73, 74 ohne jeglichen Leiterkontakt. Werden die Verbindungselemente 73, 74 geöffnet, kann ein Primärstromleiter 75 in die Rogowskispule 68 eingelegt oder aus dieser entnommen werden.

Die zusammengefassten Enden 71, 72 der Rogowskispule 68 sind in einem eigenen Kabel zusammengefasst, an welchem ein Stecker 25 mit einer zuvor beschriebenen Verriegelungsmechanik befestigt werden kann, um den Kontakt zu einem Strom-Anschluss16 des Leistungs- und Multifunktionsmessgerätes 1 herzustellen.

Innerhalb des Leistungs- und Multifunktionsmessgerätes 1 befindet sich dann ein Operationsverstärker 76 mit einem Eingangswiderstand 77 und einem Rückkopplungswiderstand 78 sowie ggf. einer jenem parallel geschalteten Rückkoppelungskapazität 79, um das gegenüber dem Klappstromwandler 41 schwächere Eingangssignal zu verstärken und von der nachfolgenden Mess- oder Wandler-Beschaltung zu entkoppeln. Diese Beschaltung mit dem Operationsverstärker 76 dient dazu, aus dem Ausgangssignal der Rogowskispule 68 ein Messsignal mit einem Messstrom von 0 bis 5 A zu erzeugen.

Ferner besteht die Möglichkeit, Messsignale - egal in welcher Form, beispielsweise als Messstrom im Bereich von mA oder A, als Messspannung im Bereich von mVoder V, als Signal eines PTC-Widerstands oder Kaltleiters oder eines NTC-Widerstands oder Heißleiters, oder eines Thermoelements - über eine separate Elektronik an das erfindungsgemäße Leistungs- und Multifunktionsmessgerät 1 anzuschließen. Dabei kann diese Elektronik mit dem Leistungs- und Multifunktionsmessgerät 1 über ein Modbus-RTU-Signal gekoppelt sein, beispielsweise über einen Modbus-RTU-Umformer. Eine solche Struktur ermöglicht die Erweiterung des Messsystems auf beliebig viele universelle Messeingänge.

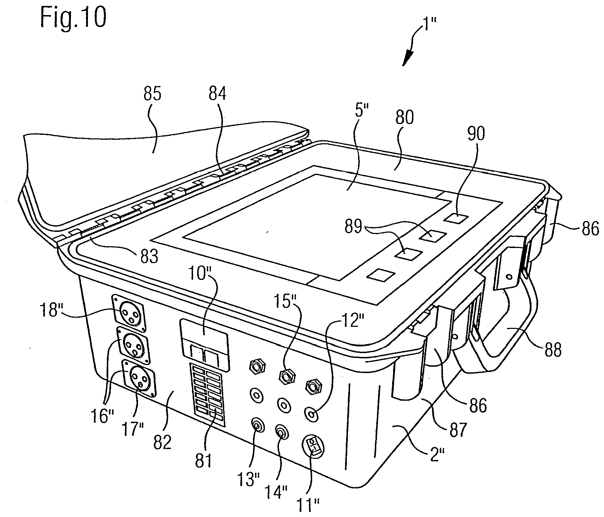

In Fig. 10 ist schließlich ein weiteres Leistungs- und Multifunktionsmessgerät 1" wiedergegeben. Dieses unterscheidet sich jedoch von dem zuvor beschriebenen eventuell durch einen andersartigen inneren Aufbau (zusätzliche Beschaltung für den Anschluss von Rogowskispulen, integrierte Festplatte zur Datenspeicherung, WLAN-Modul und/oder integriertes Logikmodul bzw. SPS-Steuerung), besonders aber durch eine andere Form des Gehäuses 2".

Hierbei ist im Gegensatz zu dem Leistungs- und Multifunktionsmessgerät 1, wo das dortige Anzeigeelement 5 in die Vorderseite 3 des Gehäuses 2 integriert ist, stattdessen das Anzeigeelement 5" in eine flache, oberseitige Abdeckung 80 eines trogförmigen Gehäuses 2" (Kunststoffkoffer) integriert.

Ferner sind im Gegensatz zu dem Leistungs- und Multifunktionsmessgerät 1, wo die dortigen Anschlüsse 10, Spannungseingänge 12 bis 14 und Stromeingänge 16 sowie Bedienelemente wie Netzschalter 11 und Sicherungen 15 an der Rückseite 9 des Gehäuses 2 angeordnet sind, stattdessen die entsprechenden Anschlüsse wie Kaltgeräte-Einbaubuchse 10, 12 bis 14 sowie 16, ferner Sicherungen 15 und Netzschalter 11 sowie Signalausgänge 81 an einer Wand 82 des trogförmigen Gehäuses 2" vorgesehen, beispielsweise an einer Seitenwand 82, im dargestellten Beispiel an der linken Stirnseite 82natürlich können diese Anschlüsse auch an anderen Stellen des Gerätes angeordnet sein, grundsätzlich sogar im Innenraum.

Ferner ist mittels eines entlang der rückwärtigen Oberkante 83 zwischen dem Korpus des trogförmigen Gehäuses 2" und dessen flacher, oberseitiger Abdeckung 80 entlang laufenden Scharniers 84 ein Deckel 85 angelenkt, welcher mit seiner Vorderkante um eben dieses Scharnier 84 nach oben geschwenkt werden kann oder herab auf die flache, oberseitige Abdeckung 80 des trogförmigen Gehäuses 2".

In herabgeschwenktem Zustand kann dieser Deckel 85 sogar mittels eines oder mehrerer Verschlüsse 86 an der Vorderseite 87 des Korpus des trogfärmigen Gehäuses 2" fixiert und dadurch geschlossen werden. Da der Deckel 85 an seiner Innenseite konkav gewölbt ist, übergreift er dabei das Anzeigeelement 5" mit Abstand und umgibt dieses dadurch schützend.

Wenn also während einer längerdauernden Messung, beispielsweise über Nacht oder gar über mehrere Tage hinweg, das Leistungs- und Multifunktionsmessgerät 1" vor Ort angeschlossen bleibt, so ist das empfindliche Anzeigeelement 5" vor Stößen, Staub, Schwitz- und/oder Kondenswasser oder vor sonstigen Einflüssen geschützt. Falls dabei der Deckel 85 transparent ausgebildet ist, kann das Anzeigeelement 5" dennoch jederzeit abgelesen werden, insbesondere ohne Öffnen des Deckels 85.

Da sich alle Anschlüsse wie Netzanschluss 10, Spannungseingänge 12 bis 14 sowie Stromeingänge 16 und Signalausgänge 81 an einer Außenseite 82 des Korpus des trogförmigen Gehäuses 2" befinden, behindern die daran angeschlossenen Kabel nicht das Schließen des Deckels 85.

Ein Handgriff 88 an der Vorderseite 87 des Gehäuses 2" erlaubt das bequeme Mitführen des tragbaren Leistungs- und Multifunktionsmessgerätes 1".

Der Kern eines erfindungsgemäßen Leistungs- und Multifunktionsmessgerätes 1, 1" ist ene arithmetisch-logische Recheneinheit, um anhand von digitalisierten Stromwerten, welche von den Eingangssingalen an den Stromeingängen 16 abgeleitet werden, und digitalisierten Spannungswerten, welche von den Eingangssignalen an den Spannungseingängen 12 bis 14 abgeleitet werden, jeweils einen oder mehrere für die Leistung bzw. einen Leistungsfluss charakteristische Parameter zu bestimmen, wie Amplitude und/oder Phase eines einpoligen Strangs oder komplexer Zeiger eines Drehstromnetzes, ferner Wirk- oder Blindleistung sowie die aus beiden zusammengesetzte Scheinleistung, Leistungsfaktor, eventuell Wirkungsgrade durch Vergleich zweier Leistungen, Anstieg oder Abfall oder sonstige dynamische Werte, Addition oder Subtraktion zweier oder mehrerer Leistungen, ferner zeitliche Integration eines oder mehrerer Werte, sowie auch Vergleiche mit einstellbaren Grenzwerten wie Schaltschwellen, etc. Diese und weitere Daten können dann an ein Energiemanagement-System übertragen und in die dortige Auswertung integriert werden. Diese Übertragung kann auf verschiedenen Wegen erfolgen, bspw. über Modbus-TCP, Modbus-RTU, Profibus, Canbus, etc.

Die Auswahl dieser zu berechnenden Parameter kann über das betreffende Anzeigeelement 5, 5" nach Art eines Touchscreens eingegeben werden oder mittels Cursorsteuertasten 89, um einen Cursor, eine Farbmarkierung oder einen Anzeigebalken auf dem Anzeigeelement 5, 5" zu verschieben, und einer Auswahltaste 90, um einen eingestellten Parameter auszuwählen.

Die ermittelten Parameter oder sonstigen Werte können wahlweise intern für eine weitere Auswertung zu einem späteren Zeitpunkt und/oder an einem anderen Ort gespeichert werden, wofür elektronische Speicher und/oder eine integrierte Festplatte, SSD bzw. Flash-Speicher, od. dgl. zur Verfügung stehen können.

Primär sind die Werte an dem Anzeigeelement 5, 5" ablesbar oder können dort als Zahlenwert oder in graphischer Weise sichtbar gemacht werden.

Auch ist es möglich, bestimmte Werte an Signalausgängen 81 zur Verfügung zu stellen, um daraus unmittelbar Aktionen abzuleiten wie bspw. das Umschalten von Relais, Ventilen, etc., insbesondere auch das Abschalten weniger relevanter Anlagenteile, um Strom-, Spannungs- oder Leistungsspitzen zu vermeiden (Energiemanagement).

Ferner können ermittelte Daten über ein Datenkabel wie bspw. ein Ethernet-Kabel oder ein USB-Kabel zu einem anderen Rechner übertragen werden, wo dann eine tiefergehende Auswertung und/oder Visualisierung der gewonnenen Daten vorgenommen werden kann. Unterstützte Protokollarten sind Modbus TCP, Modbus RTU, Bacnet, Canbus, Profibus, ASI-Bus, und weitere.

Eine solche Datenübertragung kann auch kabellos erfolgen, also beispielsweise per Funk von einem integrierten oder angeschlossenen Antennenmodul aus, bspw. via WLAN oder Bluetooth, wie auch per Infrarot oder moduliertem Licht, bspw Li-Fi.

**Bezugszeichenliste**

| | | | |
|---|---|---|---|
| 1 | Leistungsmessgerät | 26 | Vorsprung |
| 2 | Gehäuse | 27 | zylindrischer Mantel |
| 3 | Vorderseite | 28 | freie Stirnseite |
| 4 | Taste | 29 | Öffnungen |
| 5 | Anzeigeelement | 30 | schlitzförmige Öffnung |
| 6 | Rücksetzknopf | 31 | Gewinde |
| 7 | Ecke | 32 | Ring |
| 8 | Standfuß | 33 | Dichtungsring |
| 9 | Rückseite | 34 | Tülle |
| 10 | Kaltgeräte-Einbaubuchse | 35 | Ring |
| 11 | Netzschalter | 36 | Achse |
| 12 | einpoliger Spannungs-Eing. | 37 | Verriegelungselement |
| 13 | Sternpunktspannungs-Eing. | 38 | Seite |
| 14 | Erdungsspannungs-Eingang | 39 | Anlauffläche |
| 15 | Messtaster | 40 | Hakennase |
| 16 | dreipoliger Strom-Anschluss | 41 | Klappstromwandler |
| 17 | Kontakt | 42 | rechteckiger Rahmen |
| 18 | Einbau-Buchse | 43 | Durchbrechung |
| 19 | Rückseite | 44 | Flachseite |
| 20 | Lötanschluss | 45 | Druckelement |
| 21 | zylindrischer Mantel | 46 | Stirnseite |
| 22 | schlitzförmige Öffnung | 47 | Scharnier |
| 23 | Befestigungsflansch | 48 | Spalt |
| 24 | brückenförmiges Teil | 49 | Stirnseite |
| 25 | Stecker | 50 | oberer Teil |
| 51 | unterer Teil | 76 | Operationsverstärker |
| 52 | Entriegelungstaste | 77 | Eingangswiderstand |
| 53 | Standfuß | 78 | Rückkopplungswiderstand |
| 54 | Gehäuse | 79 | Rückkopplungskapazität |
| 55 | magnetisierbarer Kern | 80 | flache oberseitige Abdeckg. |
| 56 | oberes Kern-Teil | 81 | Signalausgang |
| 57 | unteres Kern-Teil | 82 | Seitenwand, Stirnseite |
| 58 | Ausnehmung des Kerns | 83 | rückwärtige Oberkante |
| 59 | Primärstromleiter | 84 | Scharnier |
| 60 | Sekundärspule | 85 | Deckel |
| 61 | Kontakt | 86 | Verschluss |
| 62 | Entriegelungstaste | 87 | Vorderseite |
| 63 | Kurzschluss-Leitung | 88 | Handgriff |
| 64 | Hallsensor | 89 | Cursorsteuertaste |
| 65 | Operationsverstärker | 90 | Auswahltaste |
| 66 | Widerstand | | |
| 67 | Masse | | |
| 68 | Rogowskispule | | |
| 69 | Leiterdraht | | |
| 70 | toroidförmiger Körper | | |
| 71 | Ende | | |
| 72 | Ende | | |
| 73 | Verbindungselement | | |
| 74 | Verbindungselement | | |
| 75 | Primärstromleiter | | |

## Patentansprüche

1. Tragbares, in ein Energiemanagementsystem (EMS) integrierbares Leistungs- und Multifunktionsmessgerät (1;1") mit wenigstens einem Anschluss (12-14) für einen Spannungsabgriff und wenigstens einem Anschluss (16) für einen Stromsensor, sowie mit einem Berechnungsmodul, um aus gemessenen Strom- und Spannungswerten die Leistung sowie vorzugsweise weitere Parameter zu berechnen, **dadurch gekennzeichnet, dass**
a) mehrere Anschlüsse (16) zum Anschluss je eines Stromsensors vorgesehen sind, so dass in einem Drehstromsystem drei Phasenströme gleichzeitig erfasst werden können, wobei
b) die Anschlüsse (16) für einen Stromsensor zum Anschliessen einer Rogowskispule und/oder eines Shunts geeignet sind, und wobei
c) mehrere Anschlüsse zum Anschluss je einer Mess-Spannung vorgesehen sind, so dass zwei oder drei Phasenspannungen und/oder zwei oder drei verkettete Spannungen gleichzeitig erfasst werden können.

2. Leistungs- und Multifunktionsmessgerät (1;1") nach Anspruch 1, **dadurch gekennzeichnet, dass** die Rogowskispule
a) eine wendelförmig gewickelte Spule umfasst sowie einen mit einem Ende jener Spule galvanisch verbundenen Rückleiter, der in oder an jener Spule enltang verläuft, so dass die freien, unverbundenen Enden der wendelförmig gewickelten Spule und des Rückleiters nahe beieinander liegen, und/oder
b) zwischen der Verbindung der wendelförmig gewickelten Spule mit dem Rückleiter einerseits und den freien Enden der wendelförmig gewickelten Spule und des Rückleiters andererseits mechanisch auftrennbar ist.

3. Leistungs- und Multifunktionsmessgerät (1;1") nach einem der vorhergehenden Ansprüche, **dadurch gekennzeichnet, dass** der zum Anschliessen einer Rogowskispule oder eines Shunts geeignete Anschluss (16)
a) einen Eingangswiderstand von 1 Ohm oder mehr aufweist, insbesondere einen Eingangswiderstand von 10 Ohm oder mehr, und/oder
b) mit einer Verstärkerschaltung versehen ist, die entweder intern in dem tragbaren Leistungs- und Multifunktionsmessgerät (1;1") integriert ist oder jenem extern vorgeschalten ist, wobei vorzugsweise der Verstärkerschaltung eingangsseitig das nicht integrierte Signal der Rogowskispule bzw. des Shunts zugeführt ist.

4. Leistungs- und Multifunktionsmessgerät (1;1") nach Anspruch 3, **dadurch gekennzeichnet, dass** geräteseitig an dem Eingang für eine Rogowskispule oder einen Shunt kein Integrator angeschlossen ist, insbesondere nicht vom Datenfluss her gesehen stromaufwärts der Verstärkerschaltung für das Ausgangssignal der Rogowskispule.

5. Leistungs- und Multifunktionsmessgerät (1;1") nach Anspruch 3 oder 4, **dadurch gekennzeichnet, dass** die Verstärkerschaltung für die Rogowskispule oder den Shunt
a) als Stomverstärker ausgebildet ist, insbesondere als Verstärker mit einem niederohmigen Ausgang, so dass das Eingangssignal in ein Stromsignal umgewandelt wird, bspw. in einen Strombereich bis 5 A abgebildet wird, oder
b) als Spannungsverstärker ausgebildet ist, insbesondere als Verstärker mit einem hochohmigen Ausgang, so dass das Eingangssignal in ein Spannungssignal umgewandelt wird, bspw. in einen Spannungsbereich bis 5 V abgebildet wird.

6. Leistungs- und Multifunktionsmessgerät (1;1") nach einem der vorhergehenden Ansprüche, **dadurch gekennzeichnet, dass** einem Strom- und/oder Spannungseingang (12-14,16), insbesondere für eine Rogowskispule, ein Analog-/Digital-Wandler nachgeschalten ist, um einen für einen Messwert charakteristischen Digitalwert zu erzeugen.

7. Leistungs- und Multifunktionsmessgerät (1;1") nach einem der vorhergehenden Ansprüche, **gekennzeichnet**
a) **durch** einen Multiplikator zur multiplikativen Verknüpfung wenigstens je eines digitalen Strom- und Spannungs-Messwertes; und/oder
b) einen Summierer zur additiven Verknüpfung mehrerer digitaler Strom-Messerte, bspw. zur Erkennung eines Erdfehlerstroms, oder zur additiven Verknüpfung mehrerer digitaler Spannungs-Messwerte, bspw. zur Ermittlung verketteter Spannungen.

8. Leistungs- und Multifunktionsmessgerät (1;1") nach einem der vorhergehenden Ansprüche, **gekennzeichnet durch**
a) wenigstens eine arithmetisch-logische Einheit, insbesondere in Form eines Logikmoduls oder eines speicherprogrammierbaren Steuerungsbausteins, oder
b) mehrere arithmetisch-logische Einheiten, insbesondere in Form eines oder mehrerer Mikroprozessoren, Mikrocontroller, Logikmodule oder speicherprogrammierbarer Steuerungsbausteine, die über ein Bus-System miteinander gekoppelt sind.

9. Leistungs- und Multifunktionsmessgerät (1;1") nach Anspruch 7 in Verbindung mit Anspruch 8, **dadurch gekennzeichnet, dass** der Multiplikator zur multiplikativen Verknüpfung wenigstens je eines digitalen Strom- und Spannungs-Messwertes, und/oder der Summierer zur additiven Verknüpfung mehrerer digitaler Strom-Messerte oder zur additiven Verknüpfung mehrerer digitaler Spannungs-Messwerte Bestandteil der in dem Leistungs- und Multifunktionsmessgerät (1;1") integrierten arithmetisch-logischen Einheit ist.

10. Leistungs- und Multifunktionsmessgerät (1;1") nach einem der vorhergehenden Ansprüche, **gekennzeichnet durch**
a) eine Anzeigeeinrichtung (5;5") zur Anzeige eines ermittelten Leistungswertes und/oder anderer elektrischer Größen; und/oder
b) einen oder mehrere, steuerbare Ausgänge, vorzugsweise Digital-Ausgänge (81); und/oder
c) eine integrierte, unterbrechungsfreie Stromversorgung.

11. Leistungs- und Multifunktionsmessgerät (1;1") nach einem der vorhergehenden Ansprüche, **dadurch gekennzeichnet, dass** es Bestandteil einer Anlagensteuerung ist, insbesondere einer speicherprogrammierbaren Steuerung, und ein oder mehrere Funktionen der Anlagensteuerung oder speicherprogrammierbaren Steuerung übernimmt.

12. Leistungs- und Multifunktionsmessgerät (1;1") nach einem der vorhergehenden Ansprüche, **dadurch gekennzeichnet, dass** wenigstens ein Anschluss (12-14,16) für einen Abgriff oder Sensor, insbesondere für einen Stromsensor, als Steckanschluss ausgebildet ist und eine formschlüssige Verriegelung für ein einzusteckendes Pendant aufweist, so dass sich die damit verriegelte Steckverbindung von selbst nicht lösen kann, umfassend ein im verriegelten Zustand von der Achse (36) der Längs- oder Steckrichtung der Steckverbindung etwa radial auskragendes Verriegelungselement (37), von welchem vorzugsweise ein radial auskragender Abschnitt nach Art einer Rastnase oder eines Sägezahns ausgebildet ist mit einer in Steckrichtung vorne liegenden Anlauframpe (39) und einer in Steckrichtung rückwärtigen, von der Steckrichtung etwa lotrecht durchsetzten Einrastfläche (40), wobei das Verriegelungselement (37) im verriegelten Zustand nach außen gedrückt wird, vorzugsweise durch ein Federelement oder durch einen Spreizungskörper, und im gelösten Zustand radial nach innen zurückgezogen ist, wobei die Stellung des Verriegelungselements (37) durch einen längs eines Gewindes (31) am Außenumfang des Steckelements (25) schraubverstellbaren Ring (32) beeinflussbar ist.

13. Leistungs- und Multifunktionsmessgerät (1;1") nach Anspruch 12, **dadurch gekennzeichnet, dass**
a) ein Steckelement (18,25), vorzugsweise das an oder in dem Leistungs- und Multifunktionsmessgerät (1;1") an- oder eingebaute Steckelement (18), bevorzugt gegenüber der freien Stirnfläche des betreffenden Steckelements (18) versenkte Kontaktstifte (17) aufweist, und/oder
b) ein Steckelement (18,25), vorzugsweise das mit dem Sensor, insbesondere dem Stromsensor, verbundene Steckelement (25), Kontaktbuchsen aufweist.

14. Leistungs- und Multifunktionsmessgerät (1;1") nach einem der vorhergehenden Ansprüche, **gekennzeichnet durch** wenigstens einen Speicher, nämlich einen Programmspeicher, worin das Programm zur Ausführung der Berechnungen des Berechnungsmoduls hinterlegt ist, insbesondere um aus gemessenen Strom- und Spannungswerten die Leistung sowie vorzugsweise weitere Parameter zu berechnen, und/oder einen Datenspeicher, in welchem die Resultate der Berechnungen des Berechnungsmoduls abspeicherbar sind, insbesondere die aus gemessenen Strom- und Spannungswerten berechnete Leistung, sowie vorzugsweise weitere Parameter und/oder Messwerte.

15. Leistungs- und Multifunktionsmessgerät (1;1") nach einem der vorhergehenden Ansprüche, **gekennzeichnet durch** wenigstens einen Schnittstellenbaustein zur digitalen Kommunikation mit externen Geräten, bspw. zur digitalen Kommunikation mit einem Programmiergerät, um das in einem Programmspeicher hinterlegbare Programm zur Ausführung der Berechnungen des Berechnungsmoduls einzuspeichern und/oder zu editieren, und/oder mit einem Gerät des Energiemanagementsystems, um in dem Datenspeicher abgespeicherte Resultate der Berechnungen des Berechnungsmoduls, insbesondere die aus gemessenen Strom- und Spannungswerten berechnete Leistung, sowie vorzugsweise weitere Parameter und/oder Messwerte, auszulesen.

## Claims

1. Portable power and multifunctional measuring device (1;1") integrable into an energy management system (EMS), said device having at least one connection (12-14) for a voltage tap and at least one connection (16) for a current sensor, as well as a calculation module for calculating the power and preferably additional parameters from the measured current and voltage values, **characterized in that:**
a) several connections (16) are provided, each of them for the connection of a current sensor, so that in a three-phase system, three phase currents can be measured simultaneously, wherein
b) the connections (16) for a current sensor are adapted for connection of a Rogowski coil and/or of a shunt, and wherein
c) several connections are provided, each of them for the connection of a measuring voltage, so that two or three phase voltages and/or two or three phase-to-phase voltages can be measured simultaneously.

2. Power and multifunctional measuring device (1;1") according to claim 1, **characterized in that** the Rogowski coil
a) comprises a helically wound coil as well as a return wire galvanically connected to one end of said coil and extending inside or along said coil, so that the free unconnected ends of the helically wound coil and of of the return wire are close to each other, and/or
b) is mechanically disconnectable between the connection of the helically wound coil with the return wire on the one hand and the free ends of the helically wound coil and the return wire on the other hand.

3. Power and multifunctional measuring device (1;1") according to one of the previous claims, **characterized in that** the connection (16) suitable for connection of a Rogowski coil or of a shunt
a) comprises an input resistance of 1 Ohm or higher, preferably an input resistance of 10 Ohm or higher, and/or
b) comprises an amplifier circuit, which is either internally integrated within the portable power and multifunctional measuring device (1;1") or externally connected upstream to it, wherein the signal of the Rogowski coil or, respectively, of the shunt, which is not integrated, is preferably fed to the amplifier circuit at its input side.

4. Power and multifunctional measuring device (1;1") according to claim 3, **characterized in that** no integrating circuit is connected to the input for the Rogowski coil or for the shunt on the device side, especially not upstream of the amplifier circuit for the output signal for the Rogowski coil, in respect to the data flow.

5. Power and multifunctional measuring device (1;1") according to claim 3 or 4, **characterized in that** the amplifier circuit for the Rogowski coil or for the shunt
a) is embodied as a current amplifier, especially as an amplifier with a low-resistance output, so that the input signal is converted into a current signal, for example is reproduced into a current range of up to 5 A, or
b) is embodied as a voltage amplifier, especially as an amplifier with a high-resistance output, so that the input signal is converted into a voltage signal, for example is reproduced into a voltage range of up to 5 V.

6. Power and multifunctional measuring device (1;1") according to one of the previous claims, **characterized in that** an analog-to-digital converter is arranged downstream of a current and/or voltage input (12-14;16), especially for a Rogowski coil, in order to generate a characteristic digital value for a measured value.

7. Power and multifunctional measuring device (1;1") according to one of the previous claims, **characterized by**
a) a multiplier for a multiplicative linking of at least each one of a digital current and voltage measuring value, and/or
b) a summator for an additive linking of several digital current measurement values, for example for a detection of a fault current, or for an additive linking of several digital voltage measurement values, for example for a determination of phase-to-phase voltages.

8. Power and multifunctional measuring device (1;1") according to one of the previous claims, **characterized by**
a) at least one arithmetic logic unit, especially in the form of a logic module or of a stored program control unit, or
b) several arithmetic logic units, especially in the form of one or more microprocessors, microcontrollers, logic modules, or stored program control units, which are coupled to each other by means of a BUS system.

9. Power and multifunctional measuring device (1;1") according to claim 7 in connection with claim 8, **characterized in that** the multiplier for a multiplicative linking of at least one of a digital measured current value with at least one of a digital measured voltage value, and/or **in that** the summator for an additive linking of several digital measured current values or for an additive linking of several digital measured voltage values is a part of the arithmetic logic unit, which is integrated in the power and multifunctional measuring device (1;1").

10. Power and multifunctional measuring device (1;1") according to one of the previous claims, **characterized by**
a) an indicator device (5;5") for displaying of a calculated power value and/or other electrical values; and/or
b) one or more controllable outputs, preferably digital outputs (81); and/or
c) an integrated uninterruptible power supply.

11. Power and multifunctional measuring device (1;1") according to one of the previous claims, **characterized in that** it is a part of a system control unit, especially of a stored program control unit, and **in that** it assumes one or more functions of the system control or stored program control unit.

12. Power and multifunctional measuring device (1;1") according to one of the previous claims, **characterized in that** at least one connection (12-14,16) for tapping or for a sensor, especially for a current sensor, is formed as a plug connection and comprises a positive locking for a matching counterpart to be inserted, so that a locked plug connection cannot unlock by itself, comprising a locking element (37), which projects in the locking state approximately radially from the axis (36) of the longitudinal or plug-in direction, a radially projecting part of which being formed like a snap-in nose or like a saw tooth, having an arranged thrust ramp (39) anterior relative to the plug-in direction and having a snap-in surface area (40) rearward relative to the plug-in direction, which is perpendiclarly penetrated, by the plug-in direction, wherein the locking element (37) is pressed outwardly in the locking state, preferably by a spring element or by a spreading element, and is radially retracted in the released state, wherein the position of the locking element (37) is influenceable by a ring (32) screwable along a thread (31) on the outer circumference of the plug-in element (25).

13. Power and multifunctional measuring device (1;1") according to claim 12, **characterized in that**
a) a plug-in element (18,25), preferably the plug-in element (18) attached to or integrated in the power and multifunctional measuring device (1;1"), comprises contact pins (17), which are preferably recessed relative to the free end face of the regarding plug-in element (18); and/or
b) a plug-in element (18,25) preferably the plug-in element connected to the sensor, especially to the current sensor, comprises a contact sockets.

14. Power and multifunctional measuring device (1;1") according to one of the previous claims, **characterized by** at least one memory, namely a program memory, where the program for the execution of calculations by the calculation module is stored, especially for the calculation of the power and preferably of additional parameters from the measured current and voltage values; and/or by a data storage, in which the results of the calculations of the calculation module are storable, especially the power calculated from the measured current and voltage values, as well as preferably additional parameters and/or values.

15. Power and multifunctional measuring device (1;1") according to one of the previous claims, **characterized by** at least one interface for a digital communication with external devices, for example for a digital communication with a programming device for saving and/or editing the program for the execution of calculations of the calculation module stored in the program memory, and/or with a device of the energy management system for reading the results stored in the data storage, which result from the calculations of the calculation module, especially the power value calculated from the measured current and voltage values, as well as other parameters and/or additional measured values.

## Revendications

1. Appareil de mesure de puissance et multifonction (1 ; 1") portable pouvant être intégré dans un système de gestion de l'énergie (SGE), comportant au moins une borne (12-14) pour une prise de tension et au moins une borne (16) pour un capteur de courant ainsi qu'un module de calcul pour calculer la puissance et de préférence d'autres paramètres à partir de valeurs de courant et de tension mesurées, **caractérisé en ce que**
a) plusieurs bornes (16) sont prévues pour le raccordement de respectivement un capteur de courant, de sorte que trois courants de phase peuvent être mesurés simultanément dans un système à courant triphasé, **en ce que**
b) les bornes (16) destinées à un capteur de courant sont adaptées à la connexion d'une bobine de Rogowski et/ou d'un shunt, et **en ce que**
c) plusieurs bornes sont prévues pour le raccordement de respectivement une tension de mesure, de sorte que deux ou trois tensions de phase et/ou deux ou trois tensions composées peuvent être mesurées simultanément.

2. Appareil de mesure de puissance et multifonction (1 ; 1") selon la revendication 1, **caractérisé en ce que** la bobine de Rogowski
a) comporte un enroulement hélicoïdal ainsi qu'un conducteur de retour relié galvaniquement à une extrémité de cet enroulement, lequel conducteur passe dans ou le long de cet enroulement, de sorte que les extrémités libres, non reliées de l'enroulement hélicoïdal et du conducteur de retour sont proches l'une de l'autre, et/ou
b) peut être coupée mécaniquement entre la connexion de l'enroule - ment hélicoïdal avec le conducteur de retour d'une part et les extrémités libres de l'enroulement hélicoïdal et du conducteur de retour d'autre part.

3. Appareil de mesure de puissance et multifonction (1 ; 1") selon l'une des revendications précédentes, **caractérisé en ce que** la borne (16) adaptée à la connexion d'une bobine de Rogowski ou d'un shunt
a) présente une impédance d'entrée égale ou supérieure à 1 ohm, en particulier une impédance d'entrée égale ou supérieure à 10 ohm et/ou
b) est pourvue d'un circuit amplificateur qui est intégré soit de manière interne dans l'appareil de mesure de puissance et multifonction (1 ; 1") portable ou qui est monté en amont de manière externe à celui-ci, le signal non intégré de la bobine de Rogowski et/ou du shunt étant de préférence amené vers le circuit amplificateur côté entrée.

4. Appareil de mesure de puissance et multifonction (1 ; 1") selon la revendication 3, **caractérisé en ce qu'**aucun intégrateur n'est raccordé côté appareil à l'entrée pour une bobine de Rogowski ou un shunt, en particulier vu du flux de données pas en amont du circuit amplificateur pour le signal de sortie de la bobine de Rogowski.

5. Appareil de mesure de puissance et multifonction (1 ; 1") selon la revendication 3 ou 4, **caractérisé en ce que** le circuit amplificateur pour la bobine de Rogowski ou le shunt
a) est réalisé sous forme d'amplificateur de courant, en particulier sous forme d'amplificateur avec une sortie de basse impédance, de sorte que le signal d'entrée est converti en un signal de courant, par exemple reproduit dans une plage de courant de jusqu'à 5 A, ou
b) est réalisé sous forme d'amplificateur de tension, en particulier sous forme d'amplificateur avec une sortie de haute impédance, de sorte que le signal d'entrée est converti en un signal de tension, par exemple reproduit dans une plage de tension de jusqu'à 5 V.

6. Appareil de mesure de puissance et multifonction (1 ; 1") selon l'une des revendications précédentes, **caractérisé en ce qu'**un convertisseur analogique-numérique est monté en aval d'une entrée de courant et/ou de tension (12-14, 16), en particulier pour une bobine de Rogowski pour générer une valeur numérique caractéristique d'une valeur mesurée.

7. Appareil de mesure de puissance et multifonction (1 ; 1") selon l'une des revendications précédentes, **caractérisé**
a) **par** un multiplicateur pour la combinaison multiplicative d'au moins une valeur mesurée numérique de courant et une valeur mesurée numérique de tension ; et/ou
b) un additionneur pour la combinaison additive de plusieurs valeurs mesurées numériques de courant, par exemple pour l'identification d'un courant de défaut à la terre, ou pour la combinaison additive de plusieurs valeurs mesurées numériques de tension, par exemple pour la détection de tensions composées.

8. Appareil de mesure de puissance et multifonction (1 ; 1") selon l'une des revendications précédentes, **caractérisé par**
a) au moins une unité arithmétique logique, en particulier sous forme d'un module logique ou d'un bloc de commande à mémoire programmable, ou
b) plusieurs unités arithmétiques logiques, en particulier sous forme d'un ou plusieurs microprocesseurs, microcontrôleurs, modules logiques ou blocs de commande à mémoire programmable qui sont couplés entre eux via un système de bus.

9. Appareil de mesure de puissance et multifonction (1 ; 1") selon la revendication 7 en association avec la revendication 8, **caractérisé en ce que** le multiplicateur pour la combinaison multiplicative d'au moins une valeur mesurée numérique de courant et une valeur mesurée numérique de tension, et/où l'additionneur pour la combinaison additive de plusieurs valeurs mesurées numériques de courant ou pour la combinaison additive de plusieurs valeurs mesurées numériques de tension est partie intégrante de l'unité arithmétique logique intégrée dans l'appareil de mesure de puissance et multifonction (1 ; 1 ").

10. Appareil de mesure de puissance et multifonction (1 ; 1") selon l'une des revendications précédentes, **caractérisé par**
a) un afficheur (5 ; 5") pour l'affichage d'une valeur de puissance calculée et/ou d'autres grandeurs électriques ; et/ou
b) une ou plusieurs sorties réglables, de préférence des sorties numériques (81) ; et/ou
c) une alimentation ininterrompue en courant intégrée.

11. Appareil de mesure de puissance et multifonction (1 ; 1") selon l'une des revendications précédentes, **caractérisé en ce qu'**il est partie intégrante d'une commande d'installation, en particulier d'une commande à mémoire programmable, et qu'il assure une ou plusieurs fonctions de la commande d'installation ou de la commande à mémoire programmable.

12. Appareil de mesure de puissance et multifonction (1 ; 1") selon l'une des revendications précédentes, **caractérisé en ce qu'**au moins une borne (12-14, 16) pour une prise ou un capteur, en particulier pour un capteur de courant, est conçue sous forme de borne enfichable et comporte un verrouillage par complémentarité de forme pour un pendant à enficher, de sorte que la connexion enfichable ainsi verrouillée ne peut pas se déconnecter d'elle-même, comprenant un élément de verrouillage (37) en saillie approximativement radial à l'état verrouillé de l'axe (36) du sens longitudinal ou enfichable de la connexion enfichable, élément de verrouillage à partir duquel un segment de préférence radialement en saillie est réalisé sous forme d'ergot d'arrêt ou de dent de scie avec une rampe de démarrage (39) située à l'avant dans le sens enfichable et une surface d'encliquetage (40) située à l'arrière dans le sens enfichable et traversée approximativement perpendiculairement par le sens enfichable, **en ce que** l'élément de verrouillage (37) à l'état verrouillé est poussé vers l'extérieur, de préférence par un élément à ressort ou par un corps d'écartement, et à l'état déverrouillé est retiré radialement vers l'intérieur, **en ce que** la position de l'élément de verrouillage (37) peut être influencée par un anneau (32) réglable par vissage le long d'un filetage (31) sur la périphérie extérieure de l'élément enfichable (25).

13. Appareil de mesure de puissance et multifonction (1 ; 1") selon la revendication 12, **caractérisé**
a) **en ce qu'**un élément enfichable (18, 25), de préférence l'élément enfichable (18) rapporté ou monté sur ou dans l'appareil de mesure de puissance et multifonction (1 ; 1"), comporte en priorité des contacts mâles (17) noyés par rapport à la face frontale libre de l'élément enfichable (18) en question, et/ou
b) un élément enfichable (18, 25), de préférence l'élément enfichable (25) relié au capteur, en particulier au capteur de courant, comporte des contacts femelles.

14. Appareil de mesure de puissance et multifonction (1 ; 1") selon l'une des revendications précédentes, **caractérisé par** au moins une mémoire, notamment une mémoire de programme, dans laquelle le programme destiné à l'exécution des calculs du module de calcul est enregistré, en particulier pour calculer la puissance ainsi que de préférence d'autres paramètres à partir des valeurs de courant et de tension mesurées, et/ou une mémoire de données, dans laquelle les résultats des calculs du module de calcul peuvent être mémorisées, en particulier la puissance calculée à partir des valeurs de courant et de tension mesurées, ainsi que de préférence d'autres paramètres et/ou valeurs mesurées.

15. Appareil de mesure de puissance et multifonction (1 ; 1") selon l'une des revendications précédentes, **caractérisé par** au moins un module interface destiné à la communication numérique avec des périphériques externes, par exemple destiné à la communication numérique avec une unité de programmation pour mettre en mémoire et/ou éditer le programme pouvant être enregistré dans une mémoire de programme pour l'exécution des calculs du module de calcul, et/ou avec un appareil du système de gestion de l'énergie pour lire les résultats des calculs du module de calcul qui sont enregistrés dans la mémoire de données, en particulier la puissance calculée à partir des valeurs de courant et de tension mesurées, ainsi que de préférence d'autres paramètres et/ou valeurs mesurées.
